# EUROPEAN PATENT APPLICATION

(11) **EP 4 358 499 A1**
(43) Date of publication of application: **24.04.2024**
(21) Application number: 23748686.5
(22) Date of filing: 02.08.2023
(51) Int. Cl.: H04M 1/02, G06F 1/16, H02J 50/10, H05K 1/14, H05K 1/16, H05K 5/03

(54) **ELECTRONIC DEVICE COMPRISING STRUCTURE FOR PREVENTING DAMAGE TO DISPLAY**

(30) Priority: 01.09.2022 KR 20220111034; 12.10.2022 KR 20220130930
(71) Applicant: Samsung Electronics Co., Ltd., Suwon-si, Gyeonggi-do 16677 (KR)
(72) Inventor: KIM, Younghun, Suwon-si Gyeonggi-do 16677 (KR); KIM, Minsoo, Suwon-si Gyeonggi-do 16677 (KR); BAEK, Soohyeon, Suwon-si Gyeonggi-do 16677 (KR); HAN, Yonggil, Suwon-si Gyeonggi-do 16677 (KR)
(74) Representative: Arnold & Siedsma
(86) International application number: PCT/KR2023/011320
(87) International publication number: WO 2024/049032

(57) **Abstract**

The electronic device according to an embodiment includes a first housing, a second housing coupled to the first housing to be slidable with respect to the first housing, a display including a second region exposed to the outside or rolled into the first housing as the second housing moves, a first coil overlapping at least a portion of the second region when the first housing is viewed from above, a sensor for measuring the temperature of the second region, and a processor. According to an embodiment, the processor is configured to obtain data representing the temperature of the second region through the sensor and provide power to the first coil based on at least a portion of the data. The first coil is configured to raise the temperature of the second region based on the provided power.

## Description

### [Technical Field]

The present disclosure relates to an electronic device including a structure for preventing damage to a display.

### [Background Art]

In order for a user to easily carry an electronic device, the electronic device may be miniaturized. Despite the miniaturization of the electronic device, there is an increasing need for the electronic device that may change the size of a display for displaying contents so that the user may receive various contents through the electronic device. For example, the electronic device may include a flexible display in which the size of the display exposed to the outside of the electronic device may be changed.

### [Disclosure]

### [Technical Solution]

An electronic device according to an embodiment may comprise a first housing, a second housing coupled with the first housing so as to slidable in a first direction or a second direction opposite to the first direction with respect to the first housing. The electronic device may comprise a display including a first region disposed on the second housing, and a second region extending from the first region exposed to an outside as the second housing moves to the first direction or rolled into the first housing as the second housing moves in the second direction. The electronic device may further comprise a first coil facing at least a portion of the second region, a sensor for measuring a temperature of the second region, and a processor. According to an embodiment, the processor may be configured to obtain data representing the temperature of the second region through the sensor and provide power to the first coil based on at least portion of the data. The first coil may be configured to raise the temperature of the second region based on the provided power.

An electronic device according to an embodiment may comprise a first housing including cover, and a second housing coupled with the first housing so as to slidable in a first direction or a second direction opposite to the first direction with respect to the first housing. The electronic device may further comprise a display including a first region disposed on the second housing, and a second region extending from the first region exposed to an outside as the second housing moves to the first direction or rolled into the first housing as the second housing moves in the second direction. The electronic device may further comprise a first coil overlapping at least a portion of the second region when the first housing is viewed from above, and contacting with the cover. The electronic device may further comprise a second coil spaced apart from the first coil, disposed on the outer surface of the cover facing the outside of the electronic device, and configured to receive power from the outside. The electronic device may further comprise a flexible circuit board connecting the first coil and the second coil, a sensor for measuring a temperature of the second region, and a processor. According to an embodiment, the processor may be configured to obtain data representing the temperature of the second region through the sensor and may be configured to provide power to the first coil based on at least portion of the data. The first coil may be configured to raise the temperature of the second region based on the provided power.

### [Description of the Drawings]

FIG. 1 is a block diagram of an electronic device in a network environment according to various embodiments.
FIG. 2A is a top plan view of an exemplary electronic device in a first state.
FIG. 2B is a bottom view of an exemplary electronic device in a first state.
FIG. 2C is a top plan view of an exemplary electronic device in a second state.
FIG. 2D is a bottom view of an exemplary electronic device in a second state.
FIGS. 3A and 3B are exploded perspective views of an exemplary electronic device.
FIG. 4A is a cross-sectional view of an exemplary electronic device in a first state.
FIG. 4B is a cross-sectional view of an exemplary electronic device in a second state.
FIG. 5A is a bottom view of an exemplary electronic device in a first state.
FIG. 5B is a perspective view illustrating a portion of an exemplary electronic device in a first state.
FIGS. 6A, 6B, and 6C are exploded views of an exemplary electronic device.
FIG. 6D is a cross-sectional view of an exemplary electronic device for line A-A' of FIG. 5A.
FIG. 7A illustrates a portion of an exemplary electronic device.
FIG. 7B is a side view of an exemplary electronic device of FIG. 7A.
FIG. 7C illustrates a portion of an exemplary electronic device.
FIG. 8 illustrates an example of an operation of a processor of an exemplary electronic device.
FIG. 9 illustrates an example of an operation of a processor of an exemplary electronic device.
FIG. 10 is a timing diagram illustrating an operation of an exemplary electronic device.

### [Mode for Invention]

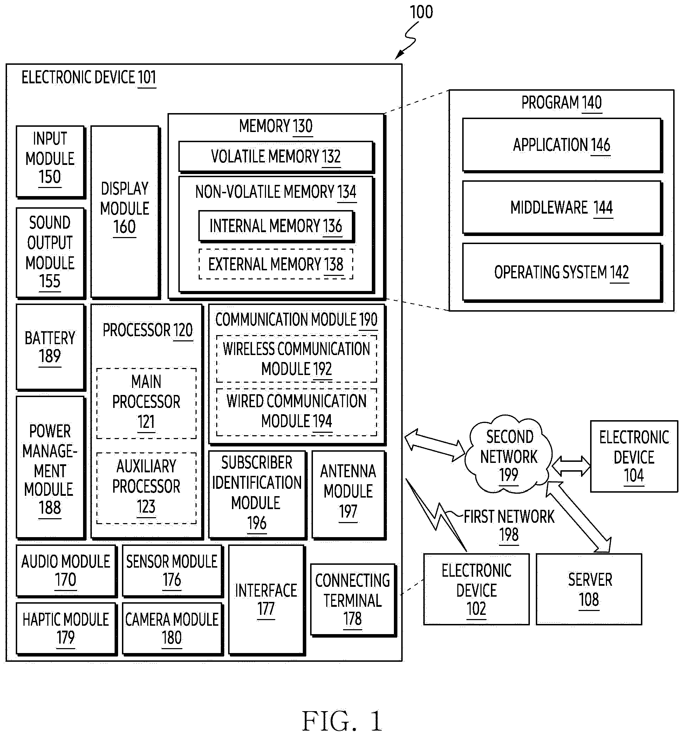

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

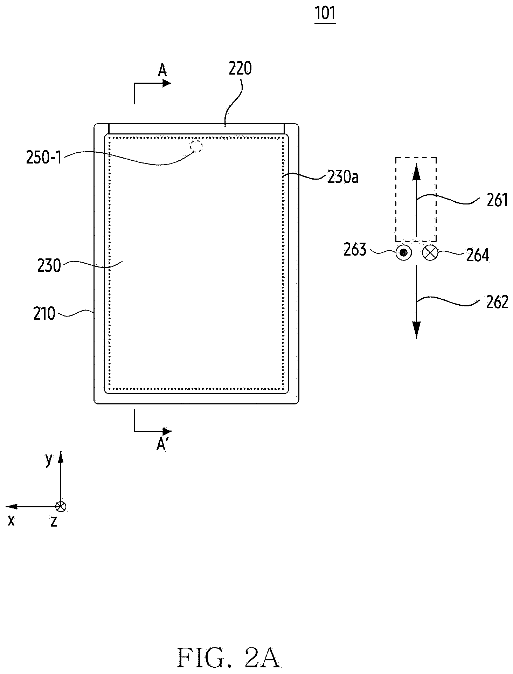

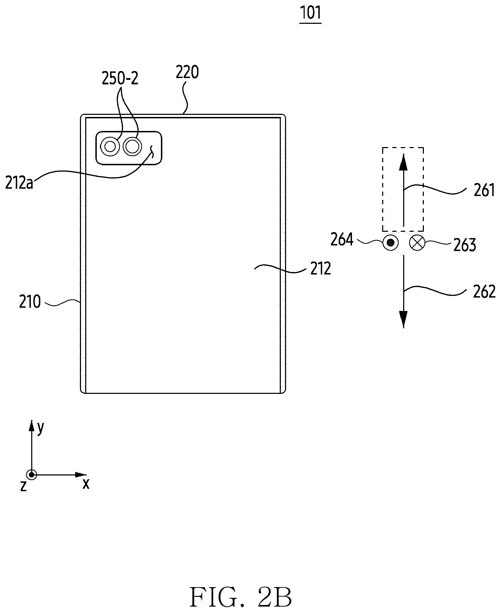

For example, the display of the display module 160 may be flexible. For example, the display may include a display region exposed to the outside of a housing of the electronic device 101 providing at least a portion of an outer surface of the electronic device. For example, because the display has flexibility, at least a portion of the display can be rolled into or slidable into the housing. For example, a size of the display region can be changed according to a size of the at least portion of the display rolled into or slid into the housing. For example, the electronic device 101 including the display can be in a plurality of states including a first state providing the display region having a first size and a second state providing the display region having a second size different form the first size. For example, the first state may be exemplified through descriptions of FIGS. 2A and 2B.

FIG. 2A is a top plan view of an exemplary electronic device 101 in a first state.

Referring to FIG. 2A, the electronic device 101 may include a first housing 210, a second housing 220 movable with respect to the first housing 210 in a first direction 261 parallel to a y-axis or in a second direction 262 parallel to the y-axis and opposite to the first direction 261, and a display 230 (e.g., the display).

For example, the electronic device 101 may be in the first state. For example, in the first state, the second housing 220 may be movable with respect to the first housing 210 in the first direction 261 among the first direction 261 and the second direction 262. For example, in the first state, the second housing 220 may not be movable in the second direction 262 with respect to the first housing 210.

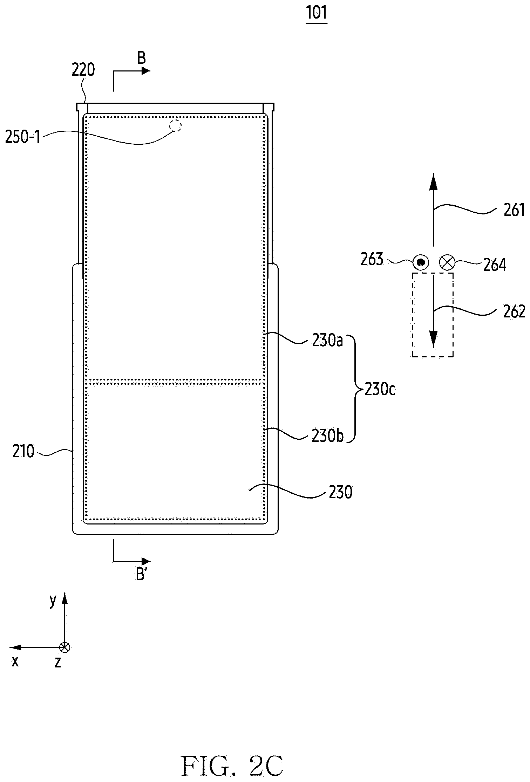

For example, in the first state, the display 230 may provide the display region having the smallest size. For example, in the first state, the display region may correspond to the region 230a. For example, although not illustrated in FIG. 2A, in the first state, a region of a display 230 (e.g., a region 230b of FIG. 2C) different from the display region 230a may be included in the first housing 210. For example, in the first state, the region may be covered by the first housing 210. For example, in the first state, the region may be rolled into the first housing 210. For example, in the first state, the region 230a may include a planar portion, unlike the region including a curved portion. However, it is not limited thereto. For example, the region 230a may include, in the first state, the curved portion extending from the planar portion and positioned in an edge portion.

For example, the first state may be referred to as a slide-in state or a closed state in terms of at least a portion of the second housing 220 being positioned in the first housing 210. For example, the first state may be referred to as a minimized state in terms of providing the display region having the smallest size. However, it is not limited thereto.

For example, the first housing 210 may include a first image sensor 250-1 in a camera module 180, which is visually exposed through a portion of the region 230a and faces a third direction 263 parallel to the z-axis. For example, the camera module 180 may be disposed to perform the function without being visually exposed through the portion of the region 230a in the internal space of the electronic device. For example, although not illustrated in FIG. 2A, the second housing 220 may include one or more second image sensors in the camera module 180 exposed through the portion of the second housing 220 and facing in a fourth direction 264 parallel to the z-axis and opposite to the third direction 263. For example, the one or more second image sensors may be illustrated through the description of FIG. 2B.

FIG. 2B is a bottom view of an exemplary electronic device in a first state.

Referring to FIG. 2B, in the first state, one or more second image sensors 250-2 disposed in a second housing 220 may be positioned within a structure disposed in a first housing 210 for the one or more second image sensors 250-2. For example, light from the outside of an electronic device 101 may be received by the one or more second image sensors 250-2 through a structure in the first state. For example, since the one or more second image sensors 250-2 is positioned within the structure in the first state, the one or more second image sensors 250-2 may be exposed through the structure in the first state. For example, the structure may be implemented in various ways. For example, the structure may be an opening or a notch. For example, the structure may be an opening 212a in a plate 212 of the first housing 210 surrounding at least a portion of the second housing 220. However, it is not limited thereto. For example, in the first state, the one or more second image sensors 250-2 included in the second housing 220 may be covered by the plate 212 of the first housing 210.

Referring back to FIG. 2A, the first state may be changed to the second state.

For example, the first state (or the second state) may be changed to the second state (or the first state) through one or more intermediate states between the first state and the second state.

For example, the first state (or the second state) may be changed to the second state (or the first state) based on a predefined user input. For example, the first state (or the second state) may be changed to the second state (or the first state) in response to a user input for a physical button exposed through a portion of the first housing 210 or the portion of the second housing 220. For example, the first state (or the second state) may be changed to the second state (or the first state) in response to a touch input for an executable object displayed in the display region. For example, the first state (or the second state) may be changed to the second state (or the first state) in response to a touch input having a contact point on the display region and a having press strength greater than the reference strength. For example, the first state (or the second state) may be changed to the second state (or the first state) in response to a voice input received through the microphone of the electronic device 101. For example, the first state (or the second state) may be changed to the second state (or the first state) in response to an external force applied to the first housing 210 and/or the second housing 220 to move the second housing 220 with respect to the first housing 210. For example, the first state (or the second state) may be changed to the second state (or the first state) in response to a user input identified by an external electronic device (e.g., earbuds or smart watch) connected to the electronic device 101. However, it is not limited thereto.

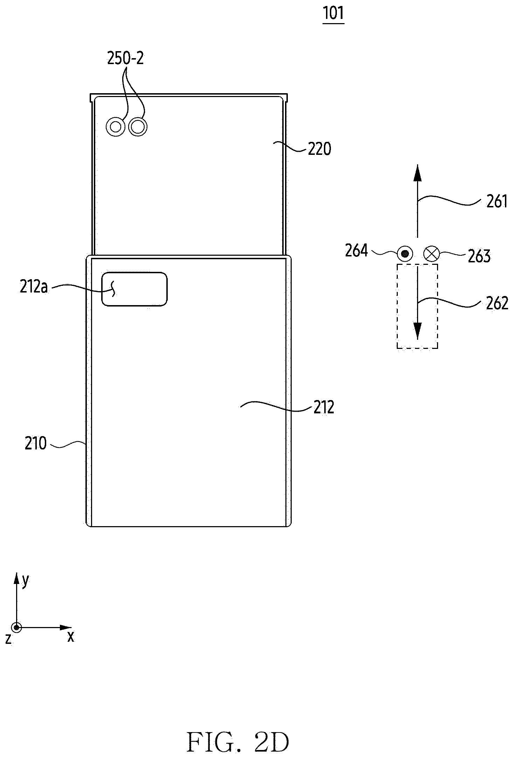

The second state may be exemplified through descriptions of FIGS. 2C and 2D.

FIG. 2C is a top plan view of an exemplary electronic device in a second state.

Referring to FIG. 2C, an electronic device 101 may be in the second state. For example, in the second state, a second housing 220 may be movable with respect to a first housing 210 in the second direction 262 among the first direction 261 and the second direction 262. For example, in the second state, the second housing 220 may not be movable in the first direction 261 with respect to the first housing 210.

For example, in the second state, a display 230 may provide a display region having the largest size. For example, in the second state, the display region may correspond to a region 230c including a region 230a and a region 230b. For example, the region 230b included in the first housing 210 in a first state may be visually exposed in the second state. For example, in the second state, the region 230a may include a planar portion. However, it is not limited thereto. For example, the region 230a may include a curved portion extending from the planar portion and positioned in an edge portion. For example, in the second state, the region 230b may include the planar portion among the planar portion and the curved portion, unlike the region 230a in the first state. However, it is not limited thereto. For example, the region 230b may include the curved portion extending from the planar portion of region 230b and positioned in the edge portion.

For example, the second state may be referred to as a slide-out state or an open state in terms of at least a portion of the second housing 220 being positioned outside the first housing 210. For example, the second state may be referred to as an extended state in terms of providing the display portion having the largest size. However, it is not limited thereto.

For example, when the state of the electronic device 101 changes from the first state to the second state, a first image sensor 250-1 facing a third direction 263 may be moved together with the region 230a according to the movement of the second housing 220 in the first direction 261. For example, although not illustrated in FIG. 2C, one or more second image sensors 250-2 facing a fourth direction 264 may be moved according to the movement of the second housing 220 in the first direction 261 when the state of the electronic device 101 is changed from the first state to the second state. For example, the relative positional relationship between the one or more second image sensors 250-2 and the structure exemplified through the description of FIG. 2B may be changed according to the movement of the one or more second image sensors 250-2. For example, the change of the relative positional relationship may be exemplified through FIG. 2D.

FIG. 2D is a bottom view of an exemplary electronic device 101 in a second state.

Referring to FIG. 2D, in the second state, one or more second image sensors 250-2 may be positioned outside the structure. For example, in the second state, the one or more second image sensors 250-2 may be positioned outside an opening 212a in a plate 212. For example, since the one or more second image sensors 250-2 are positioned outside the opening 212a in the second state, the one or more second image sensors 250-2 may be visually exposed in the second state. For example, since the one or more second image sensors 250-2 are positioned outside the structure in the second state, the relative positional relationship in the second state may be different from the relative positional relationship in the first state.

For example, in case that the electronic device 101 does not include the structure, such as the opening 212a, the one or more second image sensors 250-2 in the second state may be visually exposed, unlike one or more second image sensors 250-2 in the first state.

Although not illustrated in FIGS. 2A, 2B, 2C, and 2D, the electronic device 101 may be in an intermediate state between the first state and the second state. For example, the size of the display region in the intermediate state may be larger than the size of the display region in the first state and smaller than the size of the display region in the second state. For example, the display region in the intermediate state may correspond to a region including a portion of a region 230a and a region 230b. For example, in the intermediate state, a portion of the region 230b may be exposed, and another portion (or remaining portion) of the region 230b may be covered by first housing 210 or may be rolled into the first housing 210. However, it is not limited thereto.

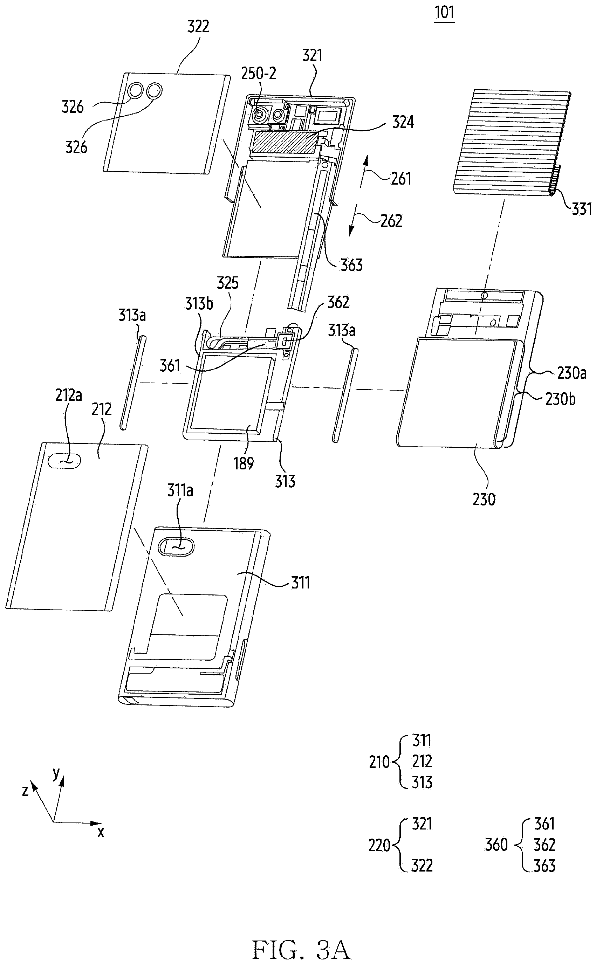

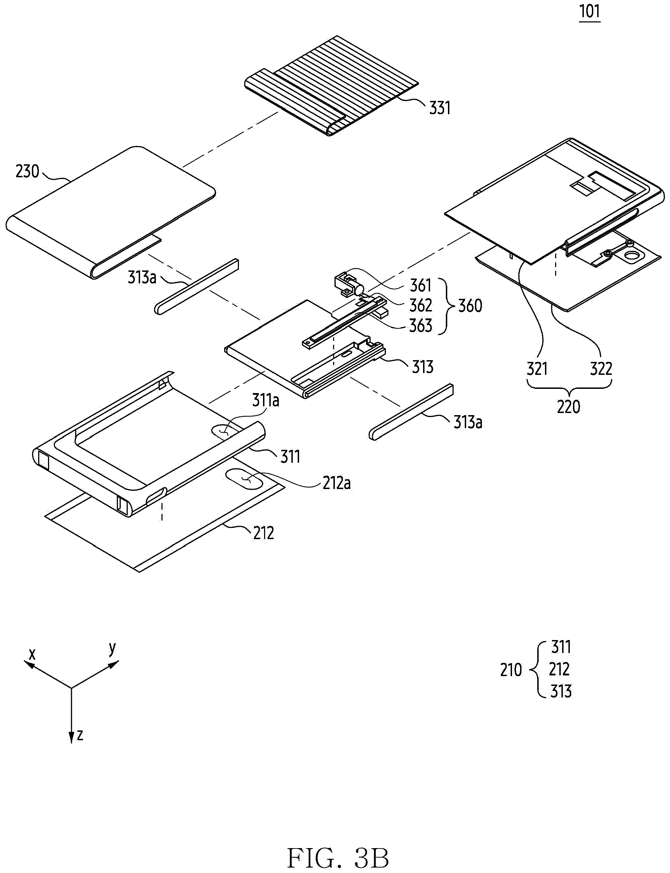

Referring back to FIG. 1, the electronic device 101 may include structures for moving a second housing (e.g., a second housing 220 of FIG. 2A) of the electronic device 101 with respect to a first housing (e.g., the first housing 210 of FIG. 2A) of the electronic device 101. For example, the structures may be exemplified through descriptions of FIGS. 3A and 3B.

FIGS. 3A and 3B are exploded perspective views of an exemplary electronic device.

Referring to FIGS. 3A and 3B, an electronic device 101 may include a first housing 210, a second housing 220, a display 230, and a driving unit 360.

For example, the first housing 210 may include a book cover 311, a plate 212, and a frame cover 313.

For example, the book cover 311 may at least partially form a side surface portion of an outer surface of the electronic device 101. For example, the book cover 311 may at least partially form a rear surface portion of the outer surface. For example, the book cover 311 may include an opening 311a for one or more second image sensors 250-2. For example, the book cover 311 may include a surface supporting the plate 212. For example, the book cover 311 may be coupled to the plate 212. For example, the book cover 311 may include the frame cover 313. For example, the book cover 311 may be coupled to the frame cover 313.

For example, the plate 212 may at least partially form the rear surface portion of the outer surface. For example, the plate 212 may include an opening 212a for the one or more second image sensors 250-2. For example, the plate 212 may be disposed on the surface of the book cover 311. For example, the opening 212a may be aligned with the opening 311a.

For example, the frame cover 313 may be at least partially surrounded by the book cover 311.

For example, the frame cover 313 may be at least partially surrounded by the display 230. For example, the frame cover 313 is at least partially surrounded by the display 230, but the position of the frame cover 313 may be maintained independently of the movement of the display 230. For example, the frame cover 313 may be arranged in relation to at least some of the components of the display 230. For example, the frame cover 313 may include rails 313a that provide (or guide) a path of the movement of at least one component of the display 230.

For example, the frame cover 313 may be coupled to at least one component of the electronic device 101. For example, the frame cover 313 may support a rechargeable battery 189. For example, the battery 189 may be supported through a recess or hole in a surface 313b of the frame cover 313. For example, the frame cover 313 may be coupled to one end of a flexible printed circuit board (FPCB) 325 on a surface of the frame cover 313. For example, although not explicitly illustrated in FIGS. 3A and 3B, another end of the FPCB 325 may be connected to a PCB 324 through at least one connector. For example, the PCB 324 may be electrically connected to another PCB (not illustrated in FIGS. 3A and 3B) that supplies power to a motor 361 through the FPCB 325.

For example, the frame cover 313 may be coupled to at least one structure of the electronic device 101 for a plurality of states including the first state and the second state. For example, the frame cover 313 may fasten the motor 361 of the driving unit 360.

For example, the second housing 220 may include a front cover 321 and a slide cover 322.

For example, the front cover 321 may be at least partially surrounded by the display 230. For example, the front cover 321 may be coupled to at least a portion of a region 230a of the display 230 surrounding the front cover 321, unlike the frame cover 313, so that the display 230 is moved along the second housing 220 that is moved with respect to the first housing 210.

For example, the front cover 321 may be coupled to at least one component of the electronic device 101. For example, the front cover 321 may be coupled to the printed circuit board (PCB) 324 including components of the electronic device 101. For example, the PCB 324 may include a processor 120 (not illustrated in FIGS. 3A and 3B). For example, the front cover 321 may include the one or more second image sensors 250-2.

For example, the front cover 321 may be coupled to the at least one structure of the electronic device 101 for the plurality of states including the first state and the second state. For example, the front cover 321 may fasten a rack gear 363 of the driving unit 360.

For example, the front cover 321 may be coupled to the slide cover 322.

For example, the slide cover 322 may be coupled to the front cover 321 to protect at least one component of the electronic device 101 coupled in the front cover 321 and/or at least one structure of the electronic device 101 coupled in the front cover 321. For example, the slide cover 322 may include a structure for the at least one component. For example, the slide cover 322 may include one or more openings 326 for the one or more second image sensors 250-2. For example, the one or more openings 326 may be aligned with the one or more second image sensors 250-2 disposed on the front cover 321. For example, the size of each of the one or more openings 326 may correspond to the size of each of the one or more second image sensors 250-2.

For example, the display 230 may include a support member 331. For example, the support member 331 may include a plurality of bars. For example, the plurality of bars may be coupled to each other.

For example, the driving unit 360 may include the motor 361, a pinion gear 362, and the rack gear 363.

For example, the motor 361 may operate based on power from the battery 189. For example, the power may be provided to the motor 361 in response to the predefined user input.

For example, the pinion gear 362 may be coupled to the motor 361 through a shaft. For example, the pinion gear 362 may be rotated based on the operation of the motor 361 transmitted through the shaft.

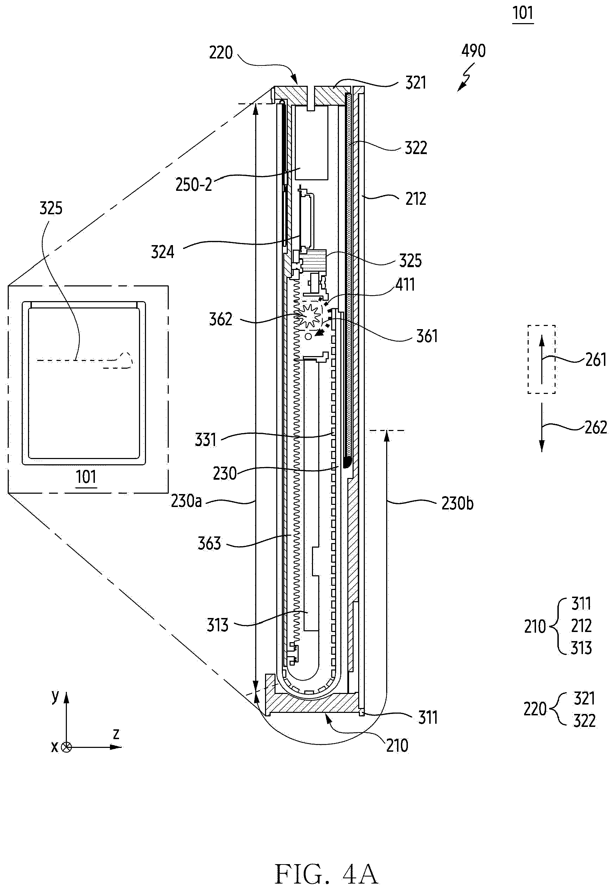

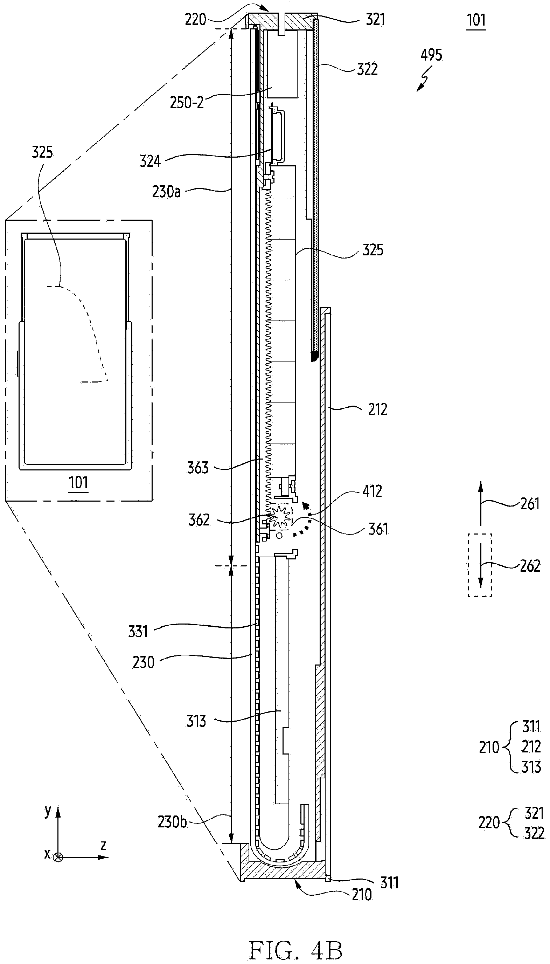

For example, the rack gear 363 may be arranged in relation to the pinion gear 362. For example, teeth of the rack gear 363 may be engaged with teeth of the pinion gear 362. For example, the rack gear 363 may move in a first direction 261 or a second direction 262 according to the rotation of the pinion gear 362. For example, the second housing 220 may be moved in the first direction 261 and the second direction 262 by the rack gear 363 that is moved according to the rotation of the pinion gear 362 due to the operation of the motor 361. For example, the first state of the electronic device 101 may be changed to a state different from the first state (e.g., the one or more intermediate states or the second state) through the movement of the second housing 220 in the first direction 261. For example, the second state of the electronic device 101 may be changed to a state (e.g., the one or more intermediate states or the first state) different from the second state through the movement of the second housing 220 in the second direction 262. For example, changing the first state to the second state by the driving unit 360 and changing the second state to the first state by the driving unit 360 may be exemplified through FIGS. 4A and 4B.

FIG. 4A is a cross-sectional view of an exemplary electronic device in a first state. FIG. 4B is a cross-sectional view of an exemplary electronic device in a second state.

Referring to FIGS. 4A and 4B, a motor 361 may be operated based at least partially on the predefined user input received in a state 490, which is the first state. For example, a pinion gear 362 may rotate in a first rotation direction 411 based at least partially on the operation of the motor 361. For example, a rack gear 363 may be moved in a first direction 261, based at least partially on the rotation of the pinion gear 362 in the first rotation direction 411. For example, since a front cover 321 in a second housing 220 fastens the rack gear 363, the second housing 220 may be moved in the first direction 261 based at least partially on the movement of the rack gear 363 in the first direction 261. For example, since the front cover 321 in the second housing 220 is coupled to at least a portion of a region 230a of a display 230 and fastens the rack gear 363, the display 230 may be moved based at least partially on the movement of the rack gear 363 in the first direction 261. For example, the display 230 may be moved along rails 313a. For example, the shape of at least some of the plurality of bars of the support member 331 of the display 230 may be changed when the state 490 is changed to a second state 495.

For example, a region 230b of the display 230 may be moved according to the movement of the display 230. For example, when the state 490 is changed to the state 495 according to the predefined user input, the region 230b may be moved through a space between a book cover 311 and a frame cover 313. For example, the region 230b in the state 495 may be visually exposed, unlike the region 230b rolled into the space in the state 490.

For example, since the front cover 321 in the second housing 220 is coupled to a PCB 324 connected to another end of a FPCB 325 and fastens the rack gear 363, the FPCB 325, the shape of the FPCB 325 may be changed when the state 490 is changed to the state 495.

The motor 361 may be operated based at least partially on the predefined user input received in the state 495. For example, the pinion gear 362 may be rotated in a second rotation direction 412 based at least partially on the operation of the motor 361. For example, the rack gear 363 may be moved in a second direction 262, based at least partially on the rotation of the pinion gear 362 in the second rotation direction 412. For example, since the front cover 321 in the second housing 220 fastens the rack gear 363, the second housing 220 may be moved in the second direction 262 based at least partially on the movement of the rack gear 363 in the second direction 262. For example, since the front cover 321 in the second housing 220 is coupled to at least a portion of the region 230a of the display 230 and fastens the rack gear 363, the display 230 may be moved based at least partially on the movement of the rack gear 363 in the second direction 262. For example, the display 230 may be moved along the rails 313a. For example, the shape of at least some of the plurality of bars of the support member 331 of the display 230 may be changed when the state 495 is changed to the state 490.

For example, the region 230b of the display 230 may be moved according to the movement of the display 230. For example, the region 230b may be moved through the space between the book cover 311 and the frame cover 313 when the state 495 is changed to the state 490 according to the predefined user input. For example, the region 230b in the state 490 may be rolled into the space, unlike the region 230b exposed in the state 495.

For example, since the front cover 321 in the second housing 220 is coupled to the PCB 324 connected to another end of the FPCB 325 and fastens the rack gear 363, the shape of the FPCB 325 may be changed when the state 495 is changed to the state 490.

FIGS. 2A to 4B illustrate the electronic device 101 in which the height of the display region is changed and the width of the display region is maintained when the first state (or the second state) is changed to the second state (or the first state) in the portrait mode, but this is for convenience of description. For example, the electronic device 101 may be implemented that the height of the display region is maintained and the width of the display region is changed, when the first state (or the second state) is changed to the second state (or the first state) in the portrait mode.

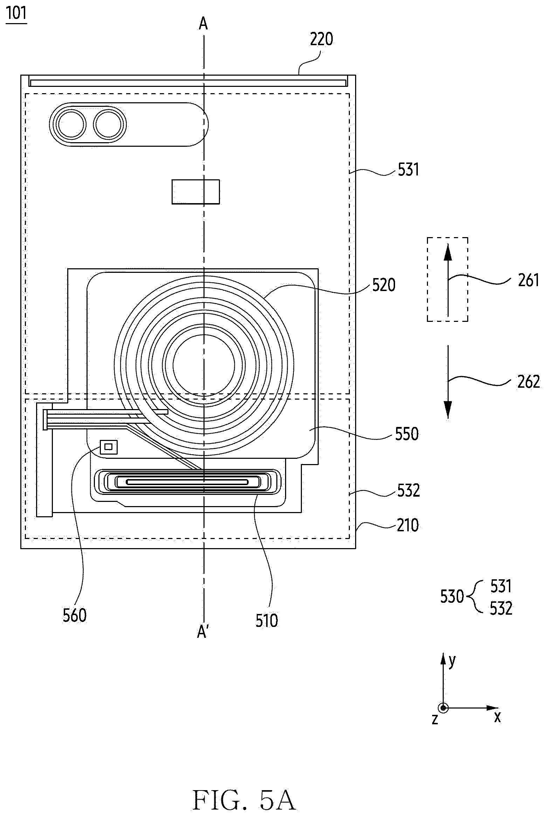

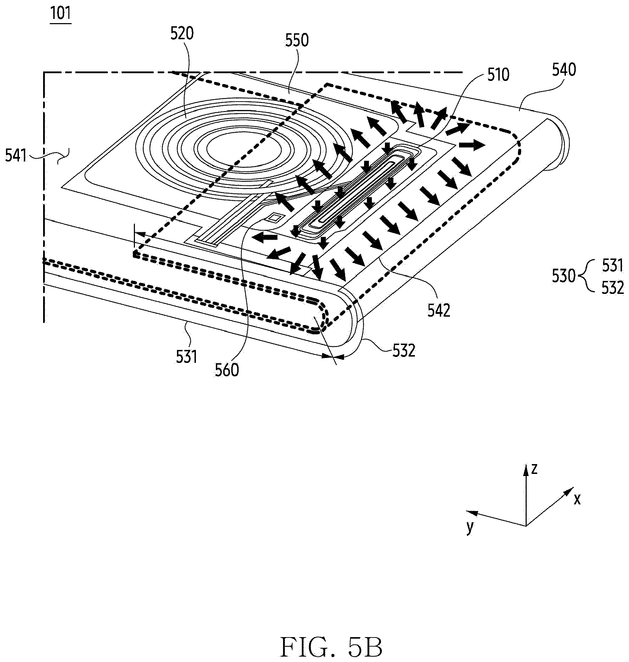

FIG. 5A is a bottom view of an exemplary electronic device in a first state. FIG. 5B is a perspective view illustrating a portion of an exemplary electronic device in a first state.

Referring to FIGS. 5A and 5B, an electronic device 101 may include a first housing 210, a second housing 220, a first coil 510, and a flexible display 530 (e.g., a display 230 of FIG. 2A).

According to an embodiment the second housing 220 may be coupled to the first housing 210 to be slidable in a first direction 261 parallel to the y-axis with respect to the first housing 210 or in a second direction 262 opposite to the first direction 261. For example, referring to FIGS. 2C, 2D, and 4B together, the second housing 220 may move by sliding in the first direction 261 parallel to the y-axis with respect to the first housing 210 from the first state. As the second housing 220 moves in the first direction 261 with respect to the first housing 210, the second housing 220 may be configured to change the electronic device 101 from the first state to the second state. For example, the second housing 220 may move by sliding in the second direction 262 parallel to the y-axis and opposite to the first direction 261 with respect to the first housing 210 from the second state. As the second housing 220 moves in the second direction 262 with respect to the first housing 210, the second housing 220 may be configured to change the electronic device 101 from the second state to the first state.

According to an embodiment, the flexible display 530 may include a first region 531 (e.g., a region 230a of FIG. 2A) and a second region 532 (e.g., a region 230b of FIG. 2C) extending from the first region 531. The first region 531 may be disposed on the second housing 220. The first region 531 may be included in the second housing 220. The second region 532 may be exposed to the outside as the second housing 220 moves in the first direction 261, or may be rolled into the first housing 210 as the second housing 220 moves in the second direction 262 opposite to the first direction 261.

For example, the first region 531 may be disposed on the second housing 220 and exposed to the outside. In the first state, the second region 532 may be disposed in the first housing 210. Since the second housing 220 moves in the first direction 261 with respect to the first housing 210, the first region 531 may move in the first direction 261 along the second housing 220 while changing from the first state to the second state. Since the second region 532 extends from the first region 531, the second region 532 may be exposed to the outside by moving along the first region 531.

For example, in the second state, the second region 532 may be exposed to the outside. While changing from the second state to the first state, since the second housing 220 moves in a second direction 262 opposite to the first direction 261 with respect to the first housing 210, the first region 531 may move in the second direction 262 along the second housing 220. Since the second region 532 extends from the first region 531, the second region 532 may be rolled into the first housing 210 by moving along the first region 531.

For example, although not illustrated, in an intermediate state between the first state and the second state, a portion of the second region 532 may be exposed to the outside. The remaining portion of the second region 532 may be disposed in the first housing 210. As the second region 532 is rolled into the first housing or deformable to be exposed to the outside of the electronic device 101, the second region 532 may be configured to provide a plurality of states.

The first state may be referred to as a slide-in state or a closed state in which the second region 532 is rolled into the first housing 210. The second state may be referred to as a slide-out state or an open state in which the second region 532 is exposed to the outside.

According to an embodiment, the first coil 510 may facing at least the portion of the second region 532. For example, the first coil 510 may overlap at least the portion of the second region 532 when the first housing 210 is viewed from above. For example, the first coil 510 may be disposed in the first housing 210. In the first state, the portion of the second region 532 disposed in the first housing 210 may overlap the first coil 510 when the first housing 210 is viewed from above. For example, in the second state, the second region 532 among the first region 531 and the second region 532 of the flexible display 530 exposed to the outside may partially overlap the first coil 510 when the first housing 210 is viewed from above. For example, in the intermediate state between the first state and the second state, when the first housing 210 is viewed from above, the first coil 510 may overlap the portion of the second region 532 disposed in the first housing 210 and the remaining portion of the second region 532 exposed to the outside.

According to an embodiment, regardless of the movement of the second housing 220 with respect to the first housing 210, the first coil 510 may be disposed to overlap at least the portion of the second region 532 when the first housing 210 is viewed from above. For example, when the first housing 210 is viewed from above, the first coil 510 may be disposed on a portion of the first housing 210 overlapping the second region 532 disposed in the first housing 210 in the first state and overlapping the second region 532 exposed to the outside in the second state.

According to an embodiment, the first coil 510 may be configured to receive power through an operation of a processor (e.g., a processor 120 of FIG. 1). The first coil 510 may be configured to raise the temperature of the second region 532 of the flexible display 530 based on the provided power. For example, the first coil 510 may be configured to heat the second region 532 through the supplied power. For example, the first coil 510 may receive the power by operating the processor 120 to supply power to the first coil 510 through a battery (e.g., a battery 189 of FIG. 1). The first coil 510 may be heated through the supplied power. The first coil 510 may overlap at least the portion of the second region 532 when the first housing 210 is viewed from above. For example, the first coil 510 may face at least the portion of the second region 532. The heated first coil 510 may transfer heat through the supplied power to the second region 532. The second region 532 may be configured to raise the temperature of the second region 532 through the transferred heat.

According to an embodiment, the first coil 510 may be configured to be disposed on the second region 532 so as to be able to heat the second region 532. In this document, when an element is referred to as being "on" another element, it should be understood that it is directly on the other element over (above) or intervening elements may exist therebetween. For example, in the present document, "B disposed on A" may represent "B disposed over A". For example, in the present document, "B disposed on A" may represent "B faced away A". For example, "the first coil 510 disposed on the second region 532" may represent "the first coil 510 contacting the second region 532". For example, "the first coil 510 disposed on the second region 532" may represent "the first coil 510 facing and separated from the second region 532".

For example, the first coil 510 may face and be separated from the second region 532. Since the first coil 510 faces the second region 532, the first coil 510 may transfer heat to the second region 532 through radiation heat transfer through power supplied through the operation of the processor 120.

For example, the first coil 510 may contact one component of the first housing 210 disposed between the second region 532 and the first coil 510. The first coil 510 may transfer heat to the second region 532 through heat conduction of the one component contacting with the first coil 510.

For example, a portion of the first coil 510 may face the second region 532, and the remaining portion except for the portion of the first coil 510 may contact one component of the first housing 210 disposed between the first coil 510 and the second region 532. The portion of the first coil 510 may transfer heat to the second region 532 through the radiation heat transfer. The remaining portion except for the portion of the first coil 510 may transfer heat to the second region 532 through the heat conduction of the one component of the first housing 210.

For example, the first coil 510 may face and be separated from the second region 532. The first coil 510 may heat air in the first housing 210 through power provided by the operation of the processor 120. The first housing 210 may include a structure that circulates air in the first housing 210 as the second housing 220 moves with respect to the first housing 210. The first coil 510 may transfer heat to the second region 532 through convection heat transfer as a portion of the air flows in the first housing 210 through the structure.

According to an embodiment, the electronic device 101 may further include a second coil 520. The second coil 520 may be spaced apart from the first coil 510. The second coil 520 may be configured to receive power from the outside of the electronic device 101. For example, the second coil 520 may wirelessly charge power to the battery 189 of the electronic device 101 through power transmitted from the outside. For example, the second coil 520 may be a near field communication (NFC) antenna for wireless communication. For example, the second coil 520, through magnetic secure transmission, may be configured to receive information from an external electronic device (e.g., an electronic device 104 of FIG. 1) to the electronic device 101 or may be configured to transmit information from the electronic device 101 to the external electronic device 104.

According to an embodiment, the second coil 520 may overlap at least the portion of the second region 532 when the first housing 210 is viewed from above. For example, the second coil 520 may be spaced apart from the first coil 510 and may be overlapped with another portion of the second region 532, which is distinct from the portion of the second region 532 overlapping the first coil 510 when the first housing 210 is viewed from above. For example, the second coil 520 may be heated through wireless power charge through wireless charging from the outside of the electronic device 101. For example, the second coil 520 may be heated by receiving power from the battery 189 of the electronic device 101 based on the operation of the processor 120. The heated second coil 520 may face the second region 532 and transfer heat to the second region 532 through the radiation heat transfer. The heated second coil 520 may contact at least one component of the electronic device 101 between the second coil 520 and the second region 532. The second coil 520 may heat the second region 532 through the heat conduction of the at least one component.

According to an embodiment, the first housing 210 may include a cover 540 (e.g., a book cover 311 of FIG. 3A). The cover 540 may enclose at least a portion of the flexible display 530. The cover 540 may include an outer surface 541 facing the outside of the electronic device 101 and an inner surface 542 opposite to the outer surface. The inner surface 542 may face the flexible display 530. The inner surface 542 may be a portion of the cover 540 that surrounds at least a portion of the flexible display 530. For example, the cover 540 may surround at least a portion of the second region 532 disposed in the first housing 210 in the first state. At least the portion of the second region 532 may be disposed between the cover 540 and a frame cover (e.g., a frame cover 313 of FIG. 3A). At least the portion of the second region 532 may face the inner surface 542 of the cover 540 facing the flexible display 530.

According to an embodiment, the cover 540 may support the first coil 510. For example, the first coil 510 may contact at least the portion of the cover 540. For example, the first coil 510 may be attached to the cover 540. The portion of the cover 540 on which the first coil 510 is disposed may overlap at least the portion of the second region 532 when the first housing 210 is viewed from above. The portion of the cover 540 on which the first coil 510 is disposed may face the second region 532. The cover 540 surrounding at least the portion of the second region 532 may be configured so that the first coil 510 overlaps at least the portion of the second region 532 when the first housing 210 is viewed from above, by supporting the first coil 510.

According to an embodiment, the second coil 520 may be disposed on the outer surface 541 of the cover 540 to receive power from the outside of the electronic device 101. For example, the second coil 520 may be configured to receive power from the external electronic device (e.g., the electronic device 104 of FIG. 1). The first housing 210 may further include a plate (e.g., plate 212 of FIG. 2A) disposed on the cover 540. The second coil 520 may contact the outer surface 541 of the cover 540 facing the plate 212. The second coil 520 may be disposed between the cover 540 and the plate 212. The second coil 520 may pass through the plate 212 and receive power received by the second coil 520.

According to an embodiment, the electronic device 101 may further include a flexible printed circuit board 550. The flexible printed circuit board 550 may connect the first coil 510 and the second coil 520. The flexible printed circuit board 550 may be another FPCB, distinct from a FPCB 325 of FIG. 3A. The second coil 520 may be electrically connected to the first coil 510 through the flexible printed circuit board 550. For example, the flexible printed circuit board 550 may be disposed on the cover 540. The flexible printed circuit board 550 may include a circuit connecting between the second coil 520 and the first coil 510. The flexible printed circuit board 550 may be electrically connected to the battery 189 of the electronic device 101. For example, the power transferred from the battery 189 to the flexible printed circuit board 550 may be provided to the first coil 510 and/or the second coil 520 through the flexible printed circuit board 550. For example, the power transferred from the battery 189 to the second coil 520 may be provided to the first coil 510 through the circuit connecting the second coil 520 and the first coil 510. For example, the power transferred from the external electronic device 104 to the second coil 520 may be provided to the first coil 510 through the circuit connecting the second coil 520 and the first coil 510. According to an embodiment, the first coil 510 and the second coil 520 may be included in the flexible printed circuit board 550.

According to an embodiment, the first coil 510, the second coil 520, and the flexible printed circuit board 550 may configure an antenna module. For example, the second coil 520 may be an NFC antenna. The second coil 520 may receive power through the wireless power charge from the outside. The second coil 520 may be configured to provide the received power to the first coil 510 connected to the second coil 520 through the flexible printed circuit board 550.

According to an embodiment, the electronic device 101 may include a sensor 560 (e.g., a sensor module 176 of FIG. 1) for measuring the temperature of the second region 532.

For example, the sensor 560 may sense the temperature inside electronic device 101. The sensor 560 may be a temperature sensor configured to sense the temperature of the second region 532 based on the temperature inside the electronic device 101.

For example, the sensor 560 may overlap the second region 532 when the first housing 210 is viewed from above, in order to sense the temperature of the second region 532. For example, the sensor 560 may face the second region 532 by being disposed on the inner surface 542 of the cover 540 enclosing at least the portion of the second region 532. For example, the sensor 560 may be disposed on the flexible printed circuit board 550 disposed on the cover 540.

For example, the sensor 560 may sense power provided to the first coil 510 and/or the second coil 520. The sensor 560 may sense the temperature of the second region 532 raised by the heating of the first coil 510 and/or the second coil 520 based on the data on the sensed power.

According to an embodiment, the processor (e.g., the processor 120 of FIG. 1) may be configured to obtain data representing the temperature of the second region 532 and may be configured to supply power to the first coil 510 based on at least a portion of the data. The processor 120 may be configured to supply the power to the second coil 520 electrically connected to the first coil 510. For example, the processor 120 may be connected to the sensor 560. The processor 120 may be configured to obtain the data representing the temperature of the second region 532 sensed by the sensor 560. Based on identifying that the data representing the temperature of the second region 532 is less than the reference temperature, the processor 120 may be configured to supply power to the first coil 510 through the battery 189 of the electronic device 101 and/or a power supply module. For example, based on identifying that the data representing the temperature of the second region 532 is less than the reference temperature, the processor 120 may be configured to supply at least a portion of power provided to the second coil 520 from the outside to the first coil 510. Based on at least a portion of the data representing the temperature of the second region 532 (e.g., data representing the temperature of the second region 532 lower than the reference temperature), the processor 120 may be configured to heat the second region 532 through heating of the first coil 510 by supplying power to the first coil 510. The processor 120 may be configured to raise the temperature of the second region 532 through heating of the first coil 510.

According to the above-described embodiment, the electronic device 101 may heat the second region 532 by including the first coil 510 and/or the second coil 520 overlapping at least the portion of the second region 532 of the flexible display when the first housing 210 is viewed from above. The electronic device 101 may raise the temperature of the second region 532 above the reference temperature, by being configured to heat the first coil 510 and/or the second coil 520 based on at least a portion of the data representing the temperature of the second region 532. The electronic device 101 may reduce damage to the second region 532 that is deformed while performing a slide-out operation in which the electronic device 101 changes from the first state to the second state at a low temperature or while performing a slide-in operation to change from the second state to the first state at the low temperature, by being configured to raise the temperature of the second region 532 above the reference temperature.

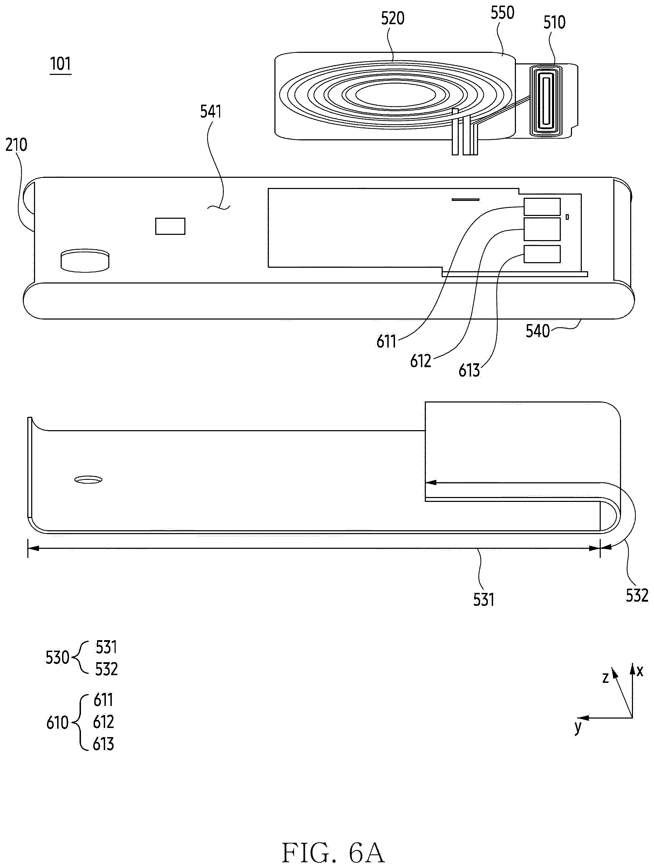

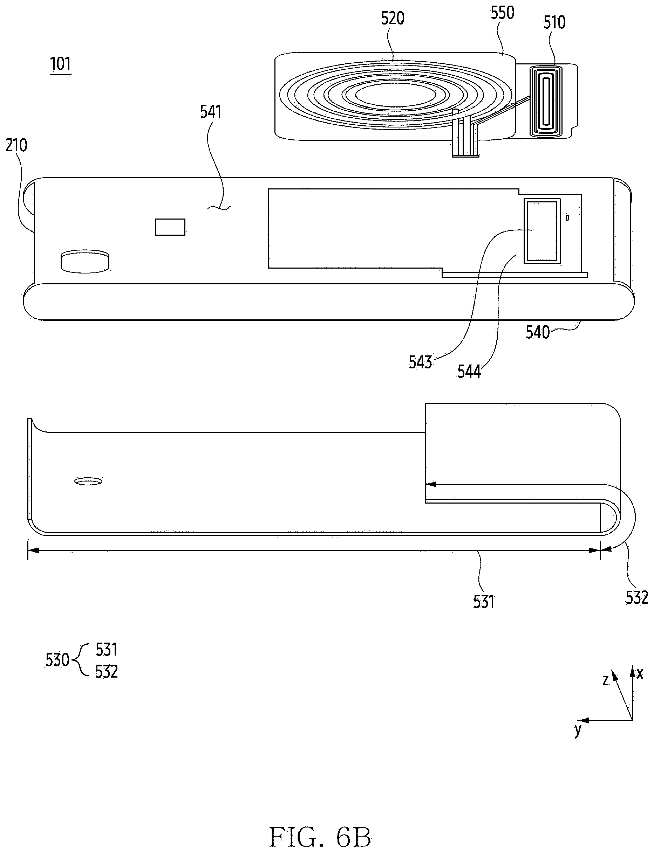

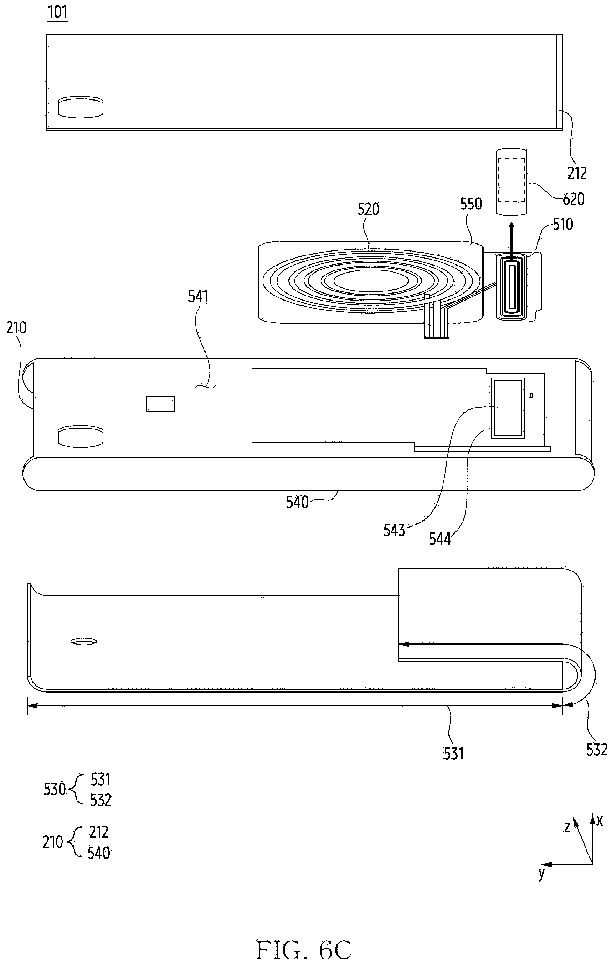

FIGS. 6A, 6B, and 6C are exploded views of an exemplary electronic device.

Referring to FIGS. 6A, 6B, and 6C, the electronic device 101 may include a first housing 210, a first coil 510, a second coil 520, a flexible display 530 (e.g., a display 230 of FIG. 2A), and a flexible printed circuit board 550. The first housing 210 may include a cover 540 (e.g., a book cover 311 of FIG. 3A).

Referring to FIG. 6A, the cover 540 may include at least one slit 610 overlapping the first coil 510. For example, the at least one slit 610 may be covered by the first coil 510. The at least one slit 610 may overlap the first coil 510 when the first housing 210 is viewed from above. The at least one slit 610 may be included in one region of the cover 540 on which the first coil 510 is disposed.

According to an embodiment, a second region 532 (e.g., region 230b of FIG. 2C) of the flexible display 530 may face the first coil 510 through the at least one slit 610. The first coil 510 may heat the second region 532 by facing the second region 532 through the at least one slit 610. For example, the first coil 510 may be disposed on an outer surface 541 facing the outside of the cover 540. The first coil 510 may overlap the at least one slit 610 when the first housing 210 is viewed from above. The first coil 510 may face at least a portion of the second region 532 surrounded by the inner surface 542, through the at least one slit 610 extending from the outer surface 541 of the cover 540 to the inner surface 542 of the cover 540. The first coil 510 may heat the second region 532 through radiation heat transfer through the at least one slit 610, by heating with power provided to the first coil 510 through a battery (e.g., a battery 189 in FIG. 1) or a power supply module.

According to the embodiment, the at least one slit 610 may include a plurality of slits contacting the first coil 510. For example, the at least one slit 610 may include slits 611, 612, and 613. The slits 611, 612, and 613 may be spaced apart from each other. Each of the slits 611, 612, and 613 may contact the first coil 510. Each of the slits 611, 612, and 613 may overlap the first coil 510 when the first housing 210 is viewed from above. The first coil 510 may be supported through a portion of the cover 540 disposed between the slits 611, 612, and 613. The first coil 510 may heat the second region 532 through each of the slits 611, 612, and 613.

Referring to FIG. 6B, the cover 540 may include a third region 543 contacting the first coil 510 and a fourth region 544 enclosing the third region 543. For example, the third region 543 may be an region overlapping the first coil 510 when the first housing 210 is viewed from above. The third region 543 may support the first coil 510. The fourth region 544 may be a region on which the second coil 520 is disposed.

According to an embodiment, the third region 543 may be separated from the fourth region 544. For example, the cover 540 may include a gap disposed between the third region 543 and the fourth region 544. The third region 543 may be attached to the first coil 510 and/or the flexible printed circuit board 550 on which the first coil 510 is disposed. For example, the cover 540 may include an insulator disposed in the gap between the third region 543 and the fourth region 544. As the third region 543 of the cover 540 on which the first coil 510 is disposed is separated from the fourth region 544 of the cover 540, the cover 540 may block heat transferred from the first coil 510 to the third region 543 from being transferred to the fourth region 544. For example, the heat transferred from the first coil 510 to the third region 543 may be transferred to the second region 532 through heat conduction of the third region 543. For example, the first coil 510 may transfer radiation heat to the second region 532 through the gap disposed between the third region 543 and the fourth region 544. According to an embodiment, the third region 543 may be formed through a double injection molding process of the cover 540.

According to an embodiment, the thermal conductivity of the third region 543 may be higher than the thermal conductivity of the fourth region 544. For example, the third region 543 may be configured with a material different from the fourth region 544 of the cover 540 enclosing the third region 543. Since the thermal conductivity of the third region 543 is higher than the thermal conductivity of the fourth region 544, the first coil 510 may raise the amount of heat transferred to the second region 532 than the fourth region 544 through the third region 543.

Referring to FIG. 6C, the first housing 210 may include a plate 212 disposed on the cover 540 and a heat insulating member 620 disposed between the cover 540 and the plate 212. The heat insulating member 620 may surround the first coil 510. For example, the heat insulating member 620 may be disposed on the flexible printed circuit board 550 on which the first coil 510 is disposed. The heat insulating member 620 may cover a portion of the first coil 510 facing the plate 212. As the heat insulating member 620 covers the portion of the first coil 510, the heat insulating member 620 may reduce damage to the plate 212 due to high heat of the first coil 510.

According to the above-described embodiment, the electronic device 101 may be configured to efficiently transfer heat from the first coil 510 to the second region 532 of the flexible display 530, by including the at least one slit 610 in the cover 540. As the third region 543 on which the first coil 510 of the cover 540 is disposed is separated from the fourth region 544 enclosing the third region 543, the electronic device 101 may be configured to efficiently transfer heat from the first coil 510 to the second region 532. The first coil 510 may reduce damage to the second region 532 that is deformed while performing a slide-out operation in which the electronic device 101 changes from the first state to the second state at a low temperature or while performing a slide-in operation to change from the second state to the first state at the low temperature, by being configured to raise the temperature of the second region 532 above the reference temperature. The first housing 210 may reduce damage to the plate 212 due to the high heat of the first coil 510 by including the heat insulating member 620 disposed between the cover 540 and the plate 212.

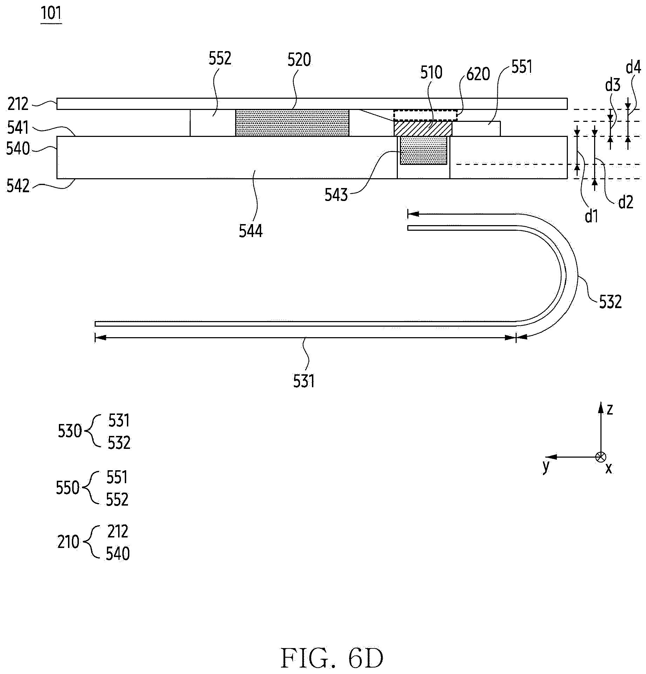

FIG. 6D is a cross-sectional view of an exemplary electronic device for line A-A' of FIG. 5A.

Referring to FIG. 6D, an electronic device 101 may include a first housing 210, a first coil 510, a second coil 520, a flexible display 530 (e.g., a display 230 of FIG. 2A), and a flexible printed circuit board 550. The first housing 210 may include a cover 540 (e.g., a book cover 311 of FIG. 3A) and a heat insulating member 620.

According to an embodiment, the cover 540 may include a third region 543 on which the first coil 510 is disposed, and a fourth region 544 surrounding the third region 543. A thickness d1 of the third region 543 may be thinner than a thickness d2 of the fourth region 544. The first coil 510 may be disposed on the outer surface 541 facing the outside of the cover 540. As the thickness d1 of the third region 543 is thinner than the thickness d2 of the fourth region 544, the cover 540 may transfer more heat transferred from the first coil 510 to the third region 543 to the second region 532 of the flexible display 530 than when the thickness of the third region 543 is the same as the thickness d4 of the fourth region 544.

According to an embodiment, the flexible printed circuit board 550 may include a first portion 551 on which the first coil 510 is disposed and a second portion 552 on which the second coil 520 is disposed extending from the first portion 551. A thickness d3 of the first portion 551 may be thinner than a thickness d4 of the second portion 552. For example, the second portion 552 may contact a plate 212. As the thickness d3 of the first portion 551 is thinner than the thickness d4 of the second portion 552, the first housing 210 may include a space in which the heat insulating member 620 may be disposed between the first portion 551 and the plate 212. For example, the heat insulating member 620 may be omitted. As the thickness of the first portion 551 is thinner than the thickness of the second portion 552, the first housing 210 may include a space between the first coil 510 and the plate 212 disposed on the first portion 551. The first housing 210 may reduce damage to the plate 212 due to high heat of the first coil 510 by including the space.

According to the above-described embodiment, as the thickness d1 of the third region 543 of the cover 540 on which the first coil 510 is disposed is thinner than the thickness d2 of the fourth region 544 of the cover 540 surrounding the third region 543, the electronic device 101 may be configured to enable efficient heat transfer from the first coil 510 to the second region 532 of the flexible display 530. As the thermal conductivity of the third region 543 is higher than the thermal conductivity of the fourth region 544, the cover 540 may be configured to enable efficient heat transfer from the first coil 510 to the second region 532 of the flexible display 530. The first coil 510 may reduce damage to the second region 532 that is deformed while performing a slide-out operation in which the electronic device 101 changes from the first state to the second state at a low temperature or while performing a slide-in operation to change from the second state to the first state, by being configured to raise the temperature of the second region 532 above the reference temperature. As the thickness d3 of the first portion 551 on which the first coil 510 is disposed is thinner than the thickness d4 of the second portion 552 on which the second coil 520 is disposed, the flexible printed circuit board 550 may reduce damage to the plate 212 toward which the first coil 510 faces due to high heat of the first coil 510.

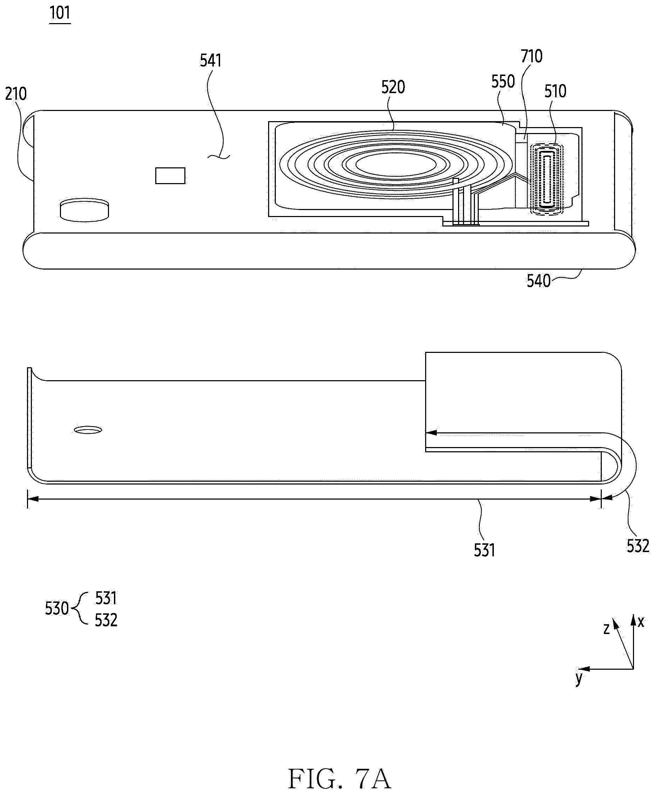

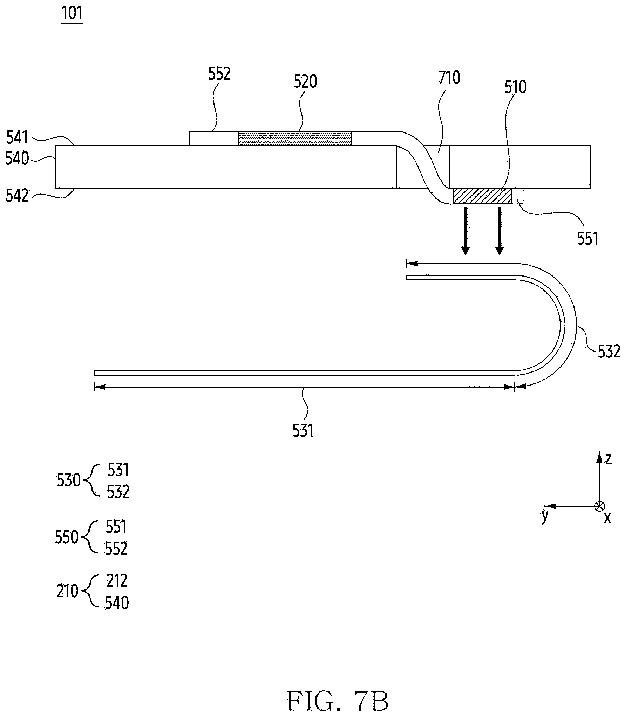

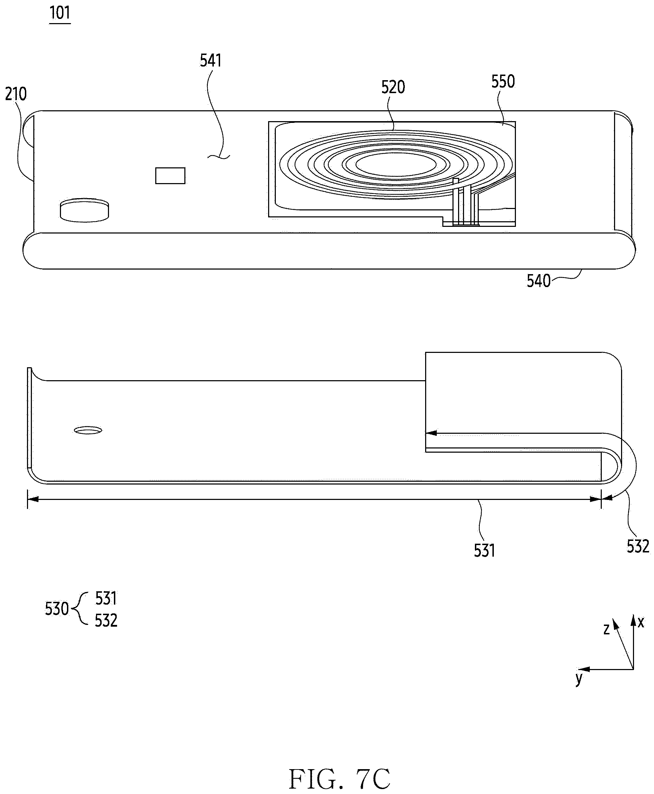

FIG. 7A illustrates a portion of an exemplary electronic device. FIG. 7B is a side view of an exemplary electronic device of FIG. 7A. FIG. 7C illustrates a portion of an exemplary electronic device.

Referring to FIGS. 7A and 7B, an electronic device 101 may include a first housing 210, a first coil 510, a second coil 520, a flexible display 530 (e.g., a display 230 of FIG. 2A), and a flexible printed circuit board 550. The first housing 210 may include a cover 540 (e.g., a book cover 311 of FIG. 3A).

According to an embodiment, an inner surface 542 facing the flexible display 530 of the cover 540 may support the first coil 510. The coil 510 may be disposed on the inner surface 542. For example, the first coil 510 may contact the inner surface 542 surrounding at least a portion of the second region 532 of the flexible display 530. The first coil 510 may contact the inner surface 542 and face the second region 532. The first coil 510 may be heated by power supplied through a battery of the electronic device 101 (e.g., a battery 189 of FIG. 1) and/or a power supply module of the electronic device. Since the first coil 510 faces the second region 532, the heated first coil 510 may transfer the heat to the second region 532.

According to an embodiment, the cover 540 may include a through hole 710 extending between an outer surface 541 facing the outside of the electronic device 101 and an inner surface 542 facing the flexible display 530. The flexible printed circuit board 550 may pass through the through hole 710. The flexible printed circuit board 550 may connect the second coil 520 disposed on the outer surface 541 and the first coil 510 disposed on the inner surface 542, by passing through the through hole 710. For example, the flexible printed circuit board 550 may include a first portion 551 on which the first coil 510 is disposed, and a second portion 552 on which the second coil 520 is disposed. The first portion 551 may be disposed on the inner surface 542 of the cover 540 facing the flexible display 530, and the second portion 552 may be disposed on the outer surface 541 of the cover 540 facing the outside. A portion of the flexible printed circuit board 550 connecting the first portion 551 and the second portion 552 may connect the first portion 551 and the second portion 552 through the through hole 710 extending from the outer surface 541 to the inner surface 542. By connecting the first portion 551 to the second portion 552, the first coil 510 and the second coil 520 may be connected.

Referring to FIG. 7C, unlike the exemplary electronic device 101 illustrated in FIGS. 7A and 7B, the first coil 510 may be omitted.

According to an embodiment, at least a portion of the second coil 520 may overlap the second region 532 of the flexible display 530 when viewed from above. The second coil 520 may be configured to heat the second region 532.

For example, the second coil 520 may contact the outer surface 541 of the cover 540 in order to receive power from the outside of the electronic device 101. The second coil 520 may be configured to heat the second region 532 by receiving power from an external electronic device (e.g., an electronic device 104 of FIG. 1).

For example, the second coil 520 may be electrically connected to a battery (e.g., a battery 189 of FIG. 1) and/or a power supply module of the electronic device 101. The second coil 520 may be configured to heat the second region 532 through power supplied from the battery 189 and/or the power supply module. For example, the flexible printed circuit board 550 may include a circuit connecting the second coil 520 and the battery 189 and/or the power supply module. By not including the first coil 510, the electronic device 101 may be configured to reduce power consumption by the first coil 510 and provide a space for an internal component of the electronic device 101.

According to the above-described embodiment, the electronic device 101 may be configured to heat the second region 532 of the flexible display 530 through the first coil 510 disposed on the inner surface 542 of the cover 540 facing the flexible display 530. The cover 540 may allow the flexible printed circuit board 550 connecting the first coil 510 and the second coil 520 to pass through, by including the through hole 710 passing through the cover 540. The first coil 510 may receive power from the second coil 520 by being connected to the second coil 520. The first coil 510 may reduce damage to the second region 532 that is deformed while performing a slide-out operation in which the electronic device 101 changes from the first state to the second state at a low temperature or while performing a slide-in operation to change from the second state to the first state at the low temperature, by disposed on the inner surface 542 and configured to heat the second region 532 to raise the temperature of the second region 532 above the reference temperature. According to an embodiment, the first coil 510 may be omitted. In case that the first coil 510 is omitted, the second coil 520 may be configured to raise the temperature of the second region 532 above the reference temperature. By not including the first coil 510, the electronic device 101 may be configured to reduce power consumption by the first coil 510 and provide the space for the internal component of the electronic device 101.

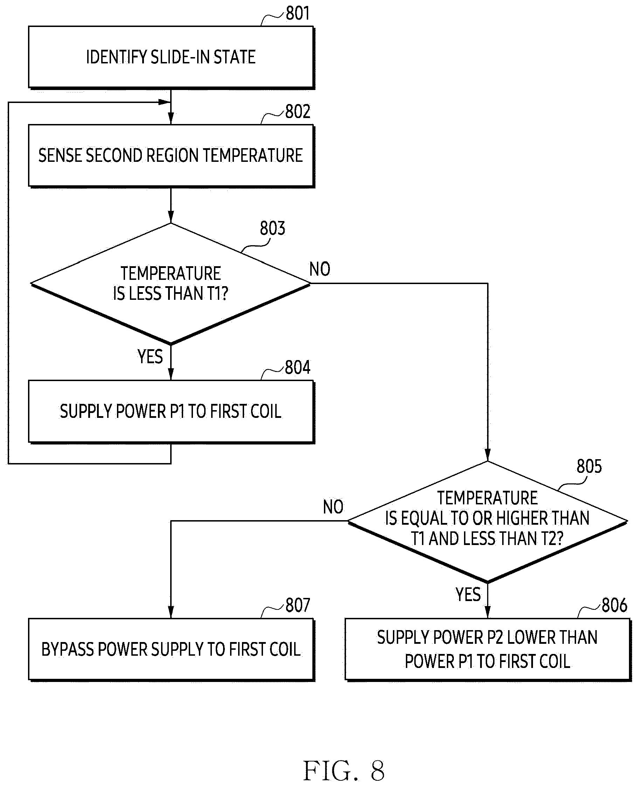

FIG. 8 illustrates an example of an operation of a processor of an exemplary electronic device.

The operation of FIG. 8 may be performed by an electronic device 101 of FIGS. 5A and 5B.

Referring to FIG. 8, in operation 801, a processor (e.g., a processor 120 of FIG. 1) may identify a flexible display (e.g., display 230 of FIG. 2A) rolled into a first housing (e.g., a first housing 210 of FIG. 2A), a second region (e.g., a region 230b of FIG. 2C or a second region 532 of FIG. 5A) of a flexible display 530 of FIG. 5A. For example, when referring to FIGS. 2A, 2B, 4A, and 5A together, the processor 120 may be configured to identify a first state corresponding to a slide-in state. For example, the processor 120 may identify the second region 532 rolled into the first housing 210 along the second housing 220 which is at least partially positioned in the first housing 210, based on identifying the second housing (e.g., the second housing 220 of FIG. 2A) at least partially positioned in the first housing 210.

In operation 802, the processor 120 may sense the temperature of the second region 532 rolled into the first housing 210. For example, the processor 120 may be configured to sense the temperature of the second region 532 or may be configured to obtain data representing the temperature, through a sensor (e.g., a sensor module 176 of FIG. 1 and a sensor 560 of FIG. 5A) configured to sense the temperature of the second region 532.

In operation 803, the processor 120 may identify whether the temperature of the second region 532 rolled into the first housing 210 is less than a threshold temperature T1. According to an embodiment, the processor 120 may bypass supplying power P1 or power P2 lower than the power P1 to a first coil (e.g., a first coil 510 of FIG. 5A), based on identifying that the temperature of the second region 532 rolled into the first housing 210 is equal to or higher than the threshold temperature T1. The processor 120 may supply the power P2 lower than the power P1 or the power P1 to the first coil 510, based on identifying that the temperature of the second region 532 rolled into the first housing 210 is less than the threshold temperature T1. According to an embodiment, the processor 120 may be configured to provide the power P1 or the power P2 lower than the power P1 to a second coil (e.g., a second coil 520 of FIG. 5A) connected to the first coil 510, based on identifying that the temperature of the second region 532 is less than the threshold temperature T1.

In operation 804, the processor 120 may be configured to provide power P1 to the first coil (e.g., the first coil 510 of FIG. 5A), based on the data representing the temperature of the second region 532 below the threshold temperature T1. For example, the processor 120 may be configured to supply power P1 to the first coil 510 through a battery (e.g., a battery 189 of FIG. 1) and/or a power supply module, while identifying that the data representing the temperature of the second region 532 is less than the threshold temperature T1 through the sensor 560 configured to sense the temperature of the second region 532. The first coil 510 may heat the second region 532 by being heated through the supplied power, thereby increasing the temperature of the second region 532.

According to an embodiment, the electronic device 101 may include the second coil (e.g., the second coil of FIG. 5A) electrically connected to the first coil 510 and configured to receive the power P1 from the processor 120 based on the data representing the temperature of the second region 532. The processor 120 may be configured to bypass providing the power P1 to the second coil 520 among the first coil 510 and the second coil 520 based on identifying that the power P1 is provided to the first coil 510 and the second coil 520 during a reference time. For example, the processor 120 may be configured to supply the power P1 to the first coil 510 and the second coil 520 to raise the temperature of the second region 532 to the temperature corresponding to the threshold temperature T1, based on the data representing the temperature of the second region 532 below the threshold temperature T1. Based on identifying that the power P1 has been supplied to the first coil 510 during a specified time, the processor 120 may be configured to bypass supplying the power P1 to the second coil 520. The processor 120 may raise the temperature of the second region 532 to the threshold temperature T1 in a shorter time than raising the temperature of the second region 532 to the threshold temperature T1 only with the first coil 510, by being configured to supply the power P1 to the second coil 520. The processor 120 may reduce the power consumption of the electronic device 101, by being configured to bypass supplying the power P1 to the second coil 520 based on identifying that the power P1 is supplied to the first coil 510 during the specified time.

In operation 805, the processor 120 may identify whether the temperature of the second region 532 is above the threshold temperature T1 and below another threshold temperature T2 higher than the threshold temperature T1. According to an embodiment, the processor 120 may be configured to provide the power P2 lower than the power P1 to the first coil 510 based on the data representing the temperature of the second region 532 above the threshold temperature T1. According to an embodiment, the processor 120 may be configured to bypass supplying power to the first coil 510, based on the data representing the temperature of the second region 532 that is equal to or higher than another threshold temperature T2 higher than the threshold temperature T1.

In operation 806, the processor 120 may be configured to maintain that the power P2 lower than the power P1 is provided to the first coil 510, based on the data representing the temperature of the second region 532 above the threshold temperature T1 and below another threshold temperature T2 higher than the threshold temperature T1. The processor 120 may reduce the power consumption of the electronic device 101, by being configured to provide another power P2 lower than the power P1 to the first coil 510, based on identifying the temperature of the second region 532 that is above the threshold temperature T1 and below another threshold temperature T2 higher than the threshold temperature T1.

In operation 807, the processor 120 may be configured to bypass providing the power P1 or the power P2 lower than the power P1 to the first coil 510, based on the data representing the temperature of the second region 532 that is equal to or higher than another threshold temperature T2 higher than the threshold temperature T1.

According to the above-described embodiment, the processor 120 of the electronic device 101 may be configured to sense the temperature of the second region 532, based on identifying the first state corresponding to the slide-in state in which the second region 532 of the flexible display 530 is rolled into the first housing 210. The processor 120 may be configured to raise the temperature of the second region 532 to the threshold temperature T1 through the first coil 510, by being configured to provide the power P1 to the first coil 510, based on the data representing the temperature of the second region 532 below the threshold temperature T1. The first coil 510 may reduce damage to the second region 532 that is deformed while performing a slide-out operation in which the electronic device 101 changes from the first state to the second state at a temperature lower than the threshold temperature T1, by being configured to raise the temperature of the second region 532 above the threshold temperature T1. The processor 120 may reduce the power consumption of the electronic device 101, by being configured to provide the power P2 lower than the power P1 to the first coil 510, or bypass power supply to the first coil 510, based on the data representing the temperature of the second region 532 equal to or higher than the threshold temperature T1.

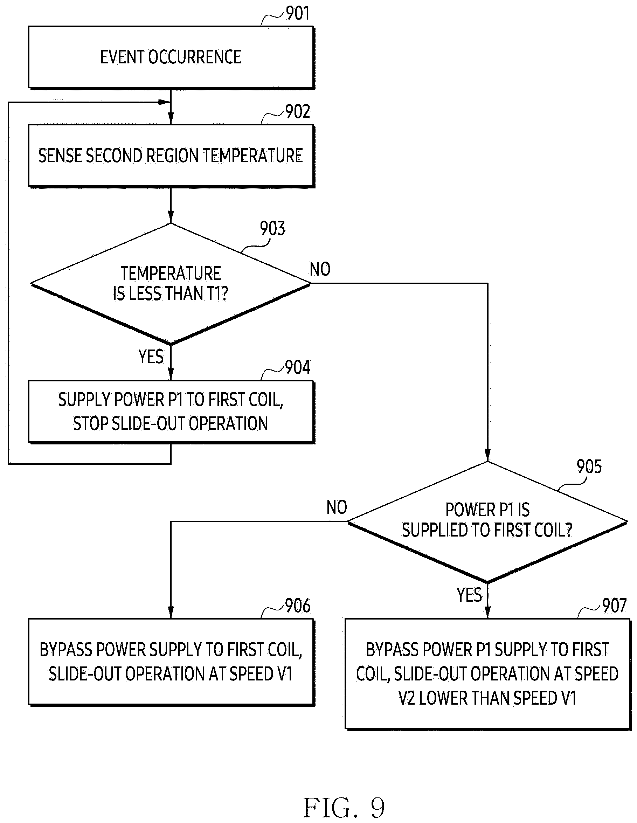

FIG. 9 illustrates an example of an operation of a processor of an exemplary electronic device.

The operation of FIG. 9 may be performed by an electronic device 101 of FIGS. 5A and 5B.

Referring to FIG. 9, in operation 901, a processor (e.g., a processor 120 of FIG. 1) may identify an event to expose a second region (e.g., a region 230b of FIG. 2C and a second region 532 of FIG. 5A) rolled into a first housing (e.g., a first housing 210 of FIG. 2A) to the outside. For example, the event for exposing the second region 532 to the outside may be a slide-out operation. For example, the event for exposing the second region 532 may be an operation in which the electronic device 101 changes from a first state in which the second region 532 is rolled into the first housing 210 to a second state in which the second region 532 is exposed to the outside. The event for exposing the second region 532 to the outside may be an operation in which the second housing 220 moves in a first direction (e.g., a first direction 261 of FIG. 1) with respect to the first housing 210 to expose the second region 532.

In operation 902, the processor 120 may sense the temperature of the second region 532, based on identifying the second region 532 rolled into the first housing 210. The operation 902 may be an operation corresponding to operation 801 and operation 802 of FIG. 8.

In operation 903, the processor 120 may identify whether the temperature of the second region 532 rolled into the first housing 210 is less than a threshold temperature T1. According to an embodiment, the processor 120 may be configured to bypass supplying the power P1 to a first coil (e.g., a first coil 510 of FIG. 5A) based on identifying that the temperature of the second region 532 rolled into the first housing 210 is above the threshold temperature T1. The processor 120 may be configured to expose the second region 532 to the outside in response to the event to expose the second region 532 to the outside, based on identifying that the temperature of the second region 532 rolled into the first housing 210 is equal to or higher than the threshold temperature T1. The processor 120 may supply the power P1 to the first coil 510, based on identifying that the temperature of the second region 532 rolled into the first housing 210 is less than the threshold temperature T1. According to an embodiment, the processor 120 may be configured to stop exposing the second region 532 rolled into the first housing 210 to the outside, based on identifying that the temperature of the second region 532 is less than the threshold temperature T1.

In operation 904, while identifying that the temperature of the second region 532 rolled into the first housing 210 is less than the threshold temperature T1, in response to the event to expose the second region 532 to the outside, the processor 120 may provide the power P1 to the first coil (e.g., the first coil 510 of FIG. 5A) to raise the temperature of the second region to the threshold temperature T1, and may stop exposing the second region 532 to the outside.

In operation 905, the processor 120 may identify whether the power P1 has been supplied to the first coil 510 while identifying that the temperature of the second region 532 rolled into the first housing 210 is above the threshold temperature T1. According to an embodiment, the processor 120 may be configured to move the second housing 220 at a speed v1 in the first direction (e.g., the first direction 261 of FIG. 2A) with respect to the first housing 210, in response to the event exposing the second region 532 to the outside, based on identifying that the power P1 is not supplied to the first coil 510. The processor 120 may be configured to move the second housing 220 at a speed v2 different from the speed v 1 in the first direction 261 with respect to the first housing 210, in response to the event, based on identifying that the power P1 is supplied to the first coil 510.

In operation 906, the processor 120 may identify that the power P1 is not supplied to the first coil 510, may bypass providing power to the first coil 510 in response to the event for exposing the second region 532 to the outside while identifying that the temperature of the second region 532 rolled into the first housing 210 is equal to or higher than the threshold temperature T1, and may move the second housing 220 in the first direction 261 with respect to the first housing 210 to expose the second region 532 to the outside.

In operation 907, the processor 120 may identify that the power P1 is supplied to the first coil 510, may bypass providing the power P1 to the first coil 510 in response to the event to expose the second region 532 to the outside while identifying that the temperature of the second region 532 rolled into the first housing 210 is equal to or higher than the threshold temperature T1, and may move the second housing 220 in the first direction 261 with respect to the first housing 210 to expose the second region 532 to the outside. The speed v2 at which the second region 532 is moved to expose the second region 532 to the outside after the power P1 is provided to the first coil 510 may be lower than the speed v1 at which the second region 532 is moved to expose the second region 532 to the outside after the power P1 provided to the first coil 510 is bypassed in the operation 906. As the speed v2 is lower than the speed v1, the processor 120 may reduce damage to the second region 532 heated through the first coil 510 by moving at a speed v1 higher than the speed v2.

According to the above-described embodiment, the processor 120 of the electronic device 101 may be configured to identify the event to expose the second region 532 to the outside in the first state corresponding to the slide-in state in which the second region 532 of the flexible display 530 is rolled into the first housing 210. The processor 120 may be configured to sense the temperature of the second region 532 in response to the event. The processor 120 may be configured to raise the temperature of the second region 532 to the threshold temperature T1 through the first coil 510, by being configured to provide the power P1 to the first coil 510, based on the data representing the temperature of the second region 532 below the threshold temperature T1. The first coil 510 may reduce damage to the second region 532 deformed while the electronic device 101 performs the operation to expose the second region 532 to the outside in response to the event at the temperature lower than the threshold temperature T1, by being configured to raise the temperature of the second region 532 above the threshold temperature T1. The processor 120 may reduce damage to the second region 532, by performing the slide-out operation at a slower speed than in case that the power P1 is not supplied, based on identifying that the power P1 has been supplied, while identifying that the temperature of the second region 532 is equal to or higher than the threshold temperature T1.

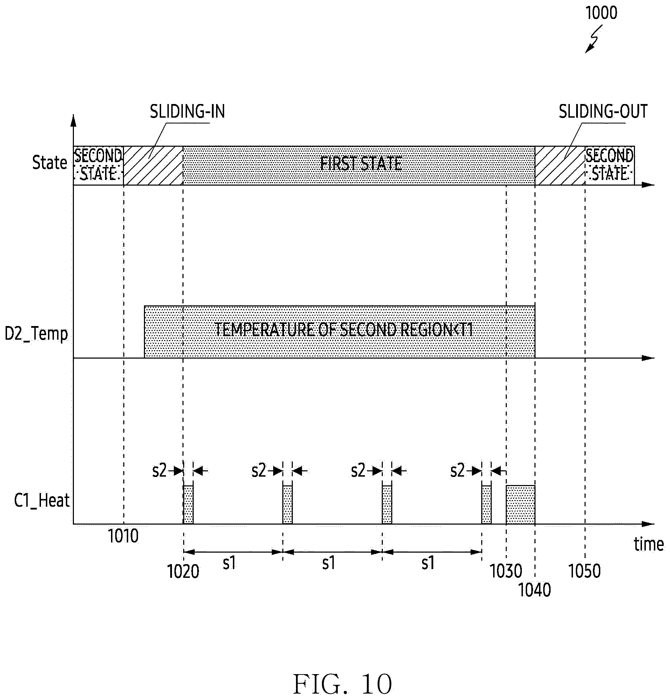

FIG. 10 is a timing diagram illustrating an operation of an exemplary electronic device.

Referring to FIG. 10, in case that a processor (e.g., a processor 120 of FIG. 1) of an electronic device (e.g., an electronic device 101 of FIG. 1) controls supplying power to a first coil (e.g., a first coil 510 of FIG. 5A) based on the temperature of a second region (e.g., a region 230b of FIG. 2A, a second region 532 of FIG. 5A) of a flexible display (e.g., a display 230 of FIG. 2A, a flexible display 530 of FIG. 5A), the timing diagram 1000 may represent a time relation between an operation to heat the second region 532 of the electronic device 101 and a slide-out operation to expose the second region 532 to the outside. A horizontal axis of each of a plurality of graphs in the timing diagram 1000 may represent time.

The processor 120 may be configured to change a state (e.g., a state of the timing diagram 1000) of electronic device 101. During a time duration between a timing 1010 and a timing 1020, it may be configured to perform a slide-in operation to change the second region 532 from a second state exposed to the outside to a first state in which the second region 532 is rolled into a first housing (e.g., a first housing 210 of FIG. 2A).

The processor 120 may be configured to sense the temperature of the second region 532 (e.g., D2_Temp of the timing diagram 1000) based on identifying the second region 532 rolled into the first housing 210 at the timing 1020. The processor 120 may be configured to identify whether the temperature of the second region 532 is less than a threshold temperature T1, through a sensor (e.g., a sensor module 176 of FIG. 1 and a sensor 560 of FIG. 5A).

The processor 120 may be configured to heat (e.g., C1_Heat of the timing diagram 1000) the first coil 510 by supplying power to the first coil 510, based on identifying that the temperature of the second region 532 rolled into the first housing 210 is below the threshold temperature T1, during the time duration between the timing 1020 and a timing 1030.

The processor 120 may identify whether the temperature of the second region 532 is less than the threshold temperature T1 during a specified time duration s2 according to a specified time interval s1, based on identifying the second region 532 rolled into the first housing 210, during the time duration between the timing 1020 and the timing 1030. The processor 120 may be configured to provide power to the first coil 510 from the timing when it identifies that the temperature is less than the threshold temperature T1, in the specified time duration s2, based on identifying that the temperature of the second region 532 is less than the threshold temperature T1. The processor 120 may be configured to bypass providing the power to the first coil 510 during the specified time duration s2 in the specified time duration s2 based on identifying that the temperature of the second region 532 is above the threshold temperature T1.

The processor 120 may identify an event for exposing the second region 532 to the outside at the timing 1030. The processor 120 may stop exposing the second region 532 to the outside based on identifying the event and identifying that the second region 532 is less than the threshold temperature T1.

The processor 120 may be configured to supply power to the first coil 510 to raise the temperature of the second region 532 to the threshold temperature T1, based on identifying that the temperature of the second region 532 is less than the threshold temperature T1 during the time duration between the timing 1030 and a timing 1040.

The processor 120 may be configured to perform the slide-out operation to change from the first state in which the second region 532 is rolled into the first housing 210 to the second state in which the second region 532 is exposed to the outside, in response to an event to expose the second region 532 to the outside, during the time duration between the timing 1040 and a timing 1050, based on identifying that the temperature of the second region 532 is equal to or higher than the threshold temperature T1 at the timing 1040.

The processor 120 may be configured to perform the slide-out operation at a speed lower than the speed of performing the slide-out operation without supplying the power based on identifying that power has been supplied to the first coil 510 during the time duration between the timing 1040 and the timing 1050.

According to the above-described embodiment, the processor 120 of the electronic device 101 may be configured to raise the temperature of the second region 532 to the threshold temperature T1 through the first coil 510, by being configured to provide power to the first coil 510 based on identifying the temperature of the second region 532 below the threshold temperature T1. The first coil 510 may reduce damage to the second region 532 that is deformed, while performing an operation to expose the second area 532 to the outside, in response to an event in which the electronic device 101 exposes the second region 532 at a temperature lower than the threshold temperature T1, by being configured to raise the temperature of the second region 532 to above the threshold temperature T1. The processor 120 may identify whether the temperature of the second region 532 is less than the threshold temperature T1 during the specified time duration s2 according to the specified time interval s1 based on identifying the state in which the second region 532 is rolled into the first housing 210. The processor 120 may reduce power consumption of the electronic device 101, by being configured to heat the second region 532 during the specified time duration s2, based on identifying that the temperature of the second region 532 is less than the threshold temperature T1 during the specified time duration s2.

According to the above-described embodiment, an electronic device (e.g., an electronic device 101 of FIG. 1) may comprise a first housing (e.g., a first housing 210 of FIG. 2A), a second housing (e.g., a second housing 220 of FIG. 2A) coupled with the first housing so as to slidable in a first direction (e.g., a first direction 261 of FIG. 2A) or a second direction (e.g., a second direction 262 of FIG. 2A) opposite to the first direction with respect to the first housing. The electronic device may further comprise a display including a first region (e.g., a region 230a of FIG. 2A, a first region 531 of FIG. 5A) disposed on the second housing, a second region (e.g., a region 230b of FIG. 2C) extending from the first region exposed to an outside as the second housing moves to the first direction or rolled into the first housing as the second housing moves in the second direction, and a display (e.g., a display 230 of FIG. 2A and a flexible display 530 of FIG. 5A) including the second region 532 of FIG. 5A. The electronic device may further comprise a first coil (e.g., a first coil 510 of FIG. 5A) facing at least a portion of the second region, a sensor (e.g., a sensor module 176 of FIG. 1, a sensor 530 of FIG. 5A) for measuring a temperature of the second region, and a processor (e.g., a processor 120 of FIG. 1). According to an embodiment, the processor may be configured to obtain data representing the temperature of the second region through the sensor and provide power to the first coil based on at least a portion of the data. The first coil may be configured to raise the temperature of the second region based on the provided power. According to the above-mentioned embodiment, the processor may heat the second region through the first coil by providing power to the first coil based on data indicating the temperature of the second region. The first coil may reduce damage to the second region that is deformed as the second housing moves with respect to the first housing at a low temperature by heating the second region. The above-mentioned embodiment may have various effects including the above-mentioned effect.

According to one embodiment, the first housing may include a cover (e.g., a book cover 311 of FIG. 3A or a cover 540 of FIG. 5A) including at least one slit (e.g., at least one slit 610, slits 611, 612, and 613 of FIG. 6A) overlapping the first coil, and the cover surrounding at least one portion of the display, and the second region may face the first coil through the at least one slit. According to the above-mentioned embodiment, the first housing may be configured to enable efficient heat transfer from the first coil to the second region by including a cover including the at least one slit. The above-mentioned embodiment may have various effects including the above-mentioned effect.

According to an embodiment, the first housing includes a cover including a third region (e.g., a third region 543 of FIG. 6B) contacting the first coil and a fourth region (e.g., a fourth region 544 of FIG. 6B) surrounding the third region, and surrounding at least a portion of the display, and wherein, the third region may be separated from the fourth region. According to the above-mentioned embodiment, the third region may be configured to enable efficient heat transfer from the first coil to the second region by being separated from the fourth region. The above-mentioned embodiment may have various effects including the above-mentioned effect.

According to an embodiment, a thickness d1 (e.g., a thickness d1 of FIG. 6D) of the third region may be thinner than a thickness d2 (e.g., a thickness d2 of FIG. 6D) of the fourth region. According to the above-mentioned embodiment, as the thickness of the third region is less than the thickness of the fourth region, the cover may be configured to enable efficient heat transfer from the first coil to the second region. The above-mentioned embodiment may have various effects including the above-mentioned effect.

According to one embodiment, a thermal conductivity of the third region may be higher than a thermal conductivity of the fourth region. According to the above-mentioned embodiment, as the thermal conductivity of the third region is greater than the thermal conductivity of the fourth region, the third region may be configured to efficiently transfer heat from the first coil to the second region. The above-mentioned embodiment may have various effects including the above-mentioned effect.

According to an embodiment, the first housing may include a cover surrounding at least one portion of the display and including an outer surface (e.g., an outer surface of FIG. 5B 541) facing the outside of the electronic device. The electronic device may further comprise a second coil (e.g., a second coil 520 of FIG. 5A) spaced apart from the first coil, disposed on the outer surface of the cover, and configured to receive power from the outside, and a flexible printed circuit board (FPCB) (e.g., a flexible printed circuit board 550 of FIG. 5A) connecting the first coil and the second coil. According to the above-mentioned embodiment, the electronic device may receive power from the outside and may provide the power to the first coil, by including the second coil and the flexible printed circuit board. The second coil may be heated through the provided power to heat the second region together with the first coil. The above-mentioned embodiment may have various effects including the above-mentioned effect.

According to an embodiment, the flexible printed circuit board may include a first portion (e.g., a first portion 551 of FIG. 6D) in which the first coil is disposed, and a second portion (e.g., a second portion 552 of FIG. 6D) extending from the first portion in which the second coil is disposed. A thickness (e.g., a thickness d3 of FIG. 6D) of the first portion may be less than a thickness (e.g., thickness d4 of FIG. 6D) of the second portion. According to the above-mentioned embodiment, as the thickness of the first portion is smaller than the thickness of the second portion, damage to a component of the electronic device disposed on the cover due to the high heat of the first coil may be reduced. The above-mentioned embodiment may have various effects including the above-mentioned effect.

According to an embodiment, the cover may further include an inner surface (e.g., an inner surface 542 of FIG. 5B) facing the display and supporting the first coil, and a through hole (e.g., a through hole 710 of FIG. 7A) extending between the outer surface and the inner surface, and wherein, the flexible printed circuit board may passe through the through hole. According to the above-mentioned embodiment, the first coil may be configured to enable efficient heat transfer from the first coil to the second region by being disposed on the inner surface. The flexible printed circuit board may connect the first coil and the second coil by passing through the through hole. The above-mentioned embodiment may have various effects including the above-mentioned effect.

According to an embodiment, the first housing may include a cover supporting the first coil, and a cover plate (e.g., a plate 212 of FIG. 2B)) disposed on the cover. The first housing may include a heat insulating member (e.g., a heat insulating member 620 of FIG. 6C) disposed between the cover and the cover plate, and surrounding the first coil. According to the above-mentioned embodiment, the first housing may protect an internal component of the electronic device from damage due to external impact by including the cover plate. The first housing may reduce damage to the cover plate due to high heat of the first coil by including the heat insulating member. The above-mentioned embodiment may have various effects including the above-mentioned effect.

According to one embodiment, the processor may identify an event for exposing the second region rolled into the first housing to the outside, and may identify whether the temperature of the second region is less than a threshold temperature (e.g., a threshold temperature T1 of FIG. 8) based on identifying the second region rolled into the first housing. In response to identifying the event identified while identifying that the temperature of the second region is less than the threshold temperature, the processor may provide the power (e.g., a power P1 of FIG. 8) to the first coil for raising the temperature of the second region to the threshold temperature, and in response to the temperature of the second region being raised above the threshold temperature, may move the second housing in the first direction with respect to the first housing to expose the second region to the outside. In response to identifying the event identified while identifying that the temperature of the second region is equal to or higher than the threshold temperature, the processor may be configured to bypass providing the power to the first coil and may be configured to move the second housing in the first direction with respect to the first housing to expose the second region to the outside. According to the above-mentioned embodiment, the processor may be configured to provide the power to the first coil, thereby reducing damage to the second region due to the operation of the electronic device at a low temperature, based on identifying the event for exposing the second region to the outside and identifying that the temperature of the second region is less than the threshold temperature. The above-mentioned embodiment may have various effects including the above-mentioned effect.

According to an embodiment, a speed (e.g., a speed v2 of FIG. 9) at which the second region is moved to expose the second region to the outside after the power is provided may be, lower than a speed(v 1) at which the second region is moved to expose the second region to the outside after providing of the power is bypassed. According to the above-mentioned embodiment, the processor may reduce damage to the second region by configuring the electronic device such that the speed v2 operates lower than the speed v1. The above-mentioned embodiment may have various effects including the above-mentioned effect.

According to an embodiment, the processor may identify whether the temperature is less than the threshold temperature during a specified time duration (e.g., a time duration s2) according to a specified time interval (e.g., a time interval s1) based on identifying the second region being rolled into the first housing. In response to identifying that the temperature is lower than the threshold temperature, the processor may provide the power to the first coil during the specified time duration from a timing when the processor identifies the temperature is less than the threshold temperature. In response to identifying that the temperature is equal to or higher than the threshold temperature, in the specified time duration, the processor may be configured to bypass providing the power to the first coil during the specified time duration. According to the above-mentioned embodiment, the processor may reduce power consumption of the electronic device, by being configured to provide the power to the first coil based on identifying the temperature of the second region below the threshold temperature during the specified time duration according to the specified time interval. The above-mentioned embodiment may have various effects including the above-mentioned effect.

According to an embodiment, the processor may be configured to provide the power to the first coil based on the data representing the temperature of the second region below the threshold temperature, and based on the data representing the temperature of the second region equal to or higher than the threshold temperature, may be configured to provide another power (e.g., a power P2 of FIG. 8) lower than the power to the first coil. According to the above-mentioned embodiment, the processor may reduce power consumption of the electronic device, by providing power lower than power provided in case that the temperature of the second region is less than the threshold temperature to the first coil, based on the data representing the temperature of the second region above the threshold temperature. The above-mentioned embodiment may have various effects including the above-mentioned effect.

According to an embodiment, the processor may be configured to keep providing another power to the first coil based on the data representing the temperature of the second region that is equal to or higher than the threshold temperature and below another threshold temperature (e.g., another threshold temperature T2 of FIG. 8) higher than the threshold temperature. Based on the data representing the temperature of the second region equal to or higher than the other threshold temperature, the processor may be configured to bypass providing the other power to the first coil. According to the above-mentioned embodiment, the processor may reduce power consumption of the electronic device, by being configured to bypass providing the power to the first coil based on the data representing the temperature that is equal to or higher than the other threshold temperature. The above-mentioned embodiment may have various effects including the above-mentioned effect.

According to an embodiment, the electronic device may further comprise a second coil electrically connected to the first coil and configured to receive the power from the processor based on the data representing the temperature of the second region, and wherein, the processor may be configured to stop providing the power to the second coil among the first coil and the second coil, based on identifying that the power is provided during reference time. According to the above-mentioned embodiment, the electronic device may heat the second region together with the first region by including the second coil. The processor may be configured to stop providing the power to the second coil based on identifying that the power is provided for a reference time, thereby reducing the power consumption of the electronic device. The above-mentioned embodiment may have various effects including the above-mentioned effect.

An electronic device according to an embodiment may comprise a first housing including cover, and a second housing coupled with the first housing so as to slidable in a first direction or a second direction opposite to the first direction with respect to the first housing. The electronic device may further comprise a display including a first region disposed on the second housing, and a second region extending from the first region exposed to an outside as the second housing moves to the first direction or rolled into the first housing as the second housing moves in the second direction. The electronic device may further comprise a first coil overlapping at least a portion of the second region when the first housing is viewed from above, and contacting with the cover. The electronic device may further comprise a second coil spaced apart from the first coil, disposed on the outer surface of the cover facing the outside of the electronic device, and configured to receive power from the outside. The electronic device may further comprise a flexible circuit board connecting the first coil and the second coil, a sensor for measuring a temperature of the second region, and a processor. According to an embodiment, the processor may be configured to obtain data representing the temperature of the second region through the sensor and may be configured to provide power to the first coil based on at least portion of the data. The first coil may be configured to raise the temperature of the second region based on the provided power. According to the above-mentioned embodiment, the processor may heat the second region through the first coil by providing power to the first coil based on data representing the temperature of the second region. The second coil may heat the second region through power provided from the outside. The electronic device may receive power from the outside and may provide the power to the first coil by including the second coil and the flexible printed circuit board. The first coil and the second coil may reduce damage to the second region that is deformed as the second housing moves with respect to the first housing at a low temperature by heating the second region. The above-mentioned embodiment may have various effects including the above-mentioned effect.

According to an embodiment, the cover may include at least one slit contacting with the first coil, and wherein, the second region may face the first coil through the at least one slit. According to the above-mentioned embodiment, the first housing may be configured to enable efficient heat transfer from the first coil to the second region, by including a cover including the at least one slit. The above-mentioned embodiment may have various effects including the above-mentioned effect.

According to an embodiment, the cover may include a third region contacting with the first coil and a fourth region surrounding the third region, and wherein, the third region may be separated from the fourth region. According to the above-mentioned embodiment, the third region may be configured to enable efficient heat transfer from the first coil to the second region by being separated from the fourth region. The above-mentioned embodiment may have various effects including the above-mentioned effect.

According to an embodiment, a thickness of the third region may be thinner than a thickness of the fourth region. According to the above-mentioned embodiments, as the thickness of the third region is smaller than the thickness of the fourth region, the cover may be configured to enable efficient heat transfer from the first coil to the second region. The above-mentioned embodiment may have various effects including the above-mentioned effect.

According to an embodiment, the flexible printed circuit board may include a first portion in which the first coil is disposed; and a second portion extending from the first portion in which the second coil is disposed, and wherein, a thickness of the first portion may be thinner than a thickness of the second portion. According to the above-mentioned embodiment, as the thickness of the first portion is smaller than the thickness of the second portion, damage to components of the electronic device disposed on the cover due to the high heat of the first coil may be reduced. The above-mentioned embodiment may have various effects including the above-mentioned effect.

According to an embodiment, the cover may further comprise an inner surface facing the display and supporting the first coil, and a through hole extending between the outer surface and the inner surface. The flexible printed circuit board may pass through the through hole. According to the above-mentioned embodiment, the first coil may be configured to enable efficient heat transfer from the first coil to the second region by being disposed on the inner surface. The flexible printed circuit board may connect the first coil and the second coil by passing through the through hole. The above-mentioned embodiment may have various effects including the above-mentioned effect.

According to an embodiment, the first housing may comprise a cover plate disposed on the cover. The first housing may further comprise a heat insulating member disposed between the cover and the cover plate and surrounding the first coil. According to the above-mentioned embodiment, the first housing may protect an internal component of the electronic device from damage due to external impact by including the cover plate. The first housing may reduce damage to the cover plate due to high heat of the first coil by including the heat insulating member. The above-mentioned embodiment may have various effects including the above-mentioned effect.

The electronic device according to various embodiments disclosed in the present document may be various types of devices. The electronic device may include, for example, a portable communication device (e.g., a smartphone), a computer device, a portable multimedia device, a portable medical device, a camera, a wearable device, or a home appliance. The electronic device according to an embodiment of the present document is not limited to the above-described devices.

The various embodiments and terms used herein are not intended to limit the technical features described herein to specific embodiments and should be understood to include various modifications, equivalents, or substitutes of the embodiment. With respect to the description of the drawings, similar reference numerals may be used for similar or related components. The singular form of the noun corresponding to the item may include one or more of the items unless clearly indicated differently in a related context. In this document, each of the phrases such as "A or B", "at least one of A and B", "at least one of A, B and C", "at least one of A, B, or C", and "at least one of A, B, or C" may include any one of the phrases together, or all possible combinations thereof. Terms such as "first", "second", or "second", or "second" may be used simply to distinguish a corresponding component from another corresponding component, and are not limited to other aspects (e.g., importance or order). When some (e.g., the first) component is referred to as "coupled" or "connected" in another (e.g., the second) component, with or without the term "functional" or "communicatively", it means that some of the components can be connected directly (e.g., wired), wirelessly, or through a third component.

The term "module" used in various embodiments of the present document may include a unit implemented in hardware, software, or firmware and be used interchangeably with terms such as logic, logic block, component, or circuitry, for example. The module may be a minimum unit or a part of the integrally configured component or the component that performs one or more functions. For example, according to an embodiment, the module may be implemented in the form of an application-specific integrated circuit (ASIC).

Various embodiments of the present document may be implemented as software (e.g., a program) including one or more instructions stored in a storage medium (or external memory) readable by a device (e.g., wearable device 100). For example, a processor (e.g., a processor) of a device (e.g., wearable device 100) may call and execute at least one of the one or more instructions stored from a storage medium. This makes it possible for the device to operate to perform at least one function according to at least one command called. The one or more instructions may include code generated by a compiler or code that may be executed by an interpreter. The device-readable storage medium may be provided in the form of a non-transitory storage medium. Here, the term 'non-transitory' only means that a storage medium is a device that is tangible and does not include a signal (e.g., electromagnetic wave), and the term does not distinguish between a case where data is semi-permanently stored and a case where it is temporarily stored.

According to an embodiment, a method according to various embodiments disclosed in the present document may be provided by being included in a computer program product. The computer program products may be traded between sellers and buyers as products. The computer program products may be distributed in the form of device-readable storage media (e.g., compact disc read only memory (CD-ROM), or distributed (e.g., downloaded or uploaded) directly or online through an application store (e.g., Play Store^{™}) or between two user devices (e.g., smartphones). In the case of online distribution, at least some of the computer program products may be temporarily stored or temporarily created on a device-readable storage medium such as a manufacturer's server, a server in an application store, or a memory in a relay server.

According to various embodiments, each of the above-described components (e.g., a module or a program) may include a single object or a plurality of objects, and some of the plurality of objects may be separated and disposed in other components. According to various embodiments, one or more components or operations of the above-described corresponding components may be omitted, or one or more other components or operations may be added. Alternatively, or additionally, a plurality of components (e.g., modules or programs) may be integrated into one component. In this case, the integrated component may perform one or more functions of each of the components in the same or similar manner as those performed by the corresponding component among the plurality of components before the integration. According to various embodiments, operations performed by a module, a program, or other components may be executed sequentially, in parallel, repeatedly, or heuristic, performed in a different order, omitted, or one or more other operations may be added.

## Claims

1. An electronic device(101) comprising:
a first housing(210);
a second housing (220) coupled with the first housing (210) so as to be slidable in a first direction (261) or a second direction (262) opposite to the first direction (261) with respect to the first housing (210);
a display including a first region (230a; 531) disposed on the second housing, and a second region (230b; 532) extending from the first region (230a; 531) exposed to an outside as the second housing(220) moves to the first direction(261) or rolled into the first housing(210) as the second housing(220) moves in the second direction(262);
a first coil (510) facing at least a portion of the second region (230b; 532);
a sensor (176; 560) for measuring a temperature of the second region (230b; 532); and
a processor;
wherein, the processor(120) is configured to obtain data representing the temperature of the second region (230b; 532) through the sensor (176; 560), and to provide power (P1) to the first coil (510) based on at least a portion of the data, and
wherein the first coil (510) is configured to raise the temperature of the second region (230b; 532) based on the provided power (P1).

2. The electronic device (101) according to claim 1, wherein, the first housing(210) includes a cover(311; 540) including at least one slit(610; 611; 612; 613) overlapping the first coil (510), the cover (311; 540) surrounding at least one portion of the display (230; 530), and
wherein the second region (230; 532) faces the first coil (510) through the at least one slit (610; 611; 612; 613).

3. The electronic device (101) according to claim 1, wherein the first housing(210) includes a cover(311; 540) including a third region (543) contacting the first coil (510); and
a fourth region (544) surrounding the third region (543), and surrounding at least a portion of the display (230; 530),
wherein the third region (543) is separated from the fourth region (544).

4. The electronic device (101) according to claim 3, wherein a thickness (d1) of the third region (543) is less than a thickness (d2) of the fourth region (544).

5. The electronic device (101) according to claim 3, wherein a thermal conductivity of the third region (543) is greater than a thermal conductivity of the fourth region (544).

6. The electronic device (101) according to claim 1, wherein the first housing(210) includes a cover(311; 540) surrounding at least one portion of the display(230; 530) and including an outer surface(541) facing the outside of the electronic device (101), and
wherein the electronic device (101) further comprises:
a second coil (520) spaced apart from the first coil (510), disposed on the outer surface (541) of the cover (311; 540), and configured to receive power from the outside; and
a flexible printed circuit board (550), 'FPCB', connecting the first coil (510) and the second coil (520).

7. The electronic device (101) according to claim 6, wherein the FPCB (550) includes:
a first portion (551) in which the first coil (510) is disposed; and
a second portion (552) extending from the first portion (551), in which the second coil (520) is disposed, and
wherein a thickness (d3) of the first portion (551) is less than a thickness (d4) of the second portion (552).

8. The electronic device (101) according to claim 6, wherein the cover (311; 540) further includes an inner surface (542) facing the display (230; 530) and supporting the first coil (510), and a through hole (710) extending between the outer surface (541) and the inner surface (542), and
wherein the FPCB (550) passes through the through hole (710).

9. The electronic device (101) according to claim 1,
wherein, the first housing(210) includes:
a cover(311; 540) supporting the first coil(510);
a cover plate(212) disposed on the cover(311; 540); and
a heat insulating member(620) disposed between the cover(311; 540) and the cover plate(212), and surrounding the first coil(510).

10. The electronic device (101) according to claim 1, wherein the processor (120) is configured to:
identify an event for exposing the second region (230b; 532) rolled into the first housing (210) to the outside;
identify whether the temperature of the second region (230b; 532) is less than a threshold temperature (T1) based on identifying the second region (230b; 532) rolled into the first housing(210);
in response to identifying the event identified while identifying that the temperature of the second region (230b; 532) is less than the threshold temperature (T1):
provide the power (P1) to the first coil (510) for raising the temperature of the second region (230b; 532) to the threshold temperature (T1); and
in response to the temperature of the second region (230b; 532) being raised above the threshold temperature (T1), move the second housing (220) in the first direction (261) with respect to the first housing (210) to expose the second region (230b; 532) to the outside, and
in response to identifying the event identified while identifying that the temperature of the second region (230b; 532) is equal to or higher than the threshold temperature (T1):
bypass providing the power (P1) to the first coil (510); and
move the second housing (220) in the first direction (261) with respect to the first housing (210) to expose the second region (230b; 532) to the outside.

11. The electronic device (101) according to claim 10, wherein a speed (v2) at which the second region (230b; 532) is moved to expose the second region (230b; 532) to the outside after the power (P1) is provided is lower than a speed (v1) at which the second region (230b; 532) is moved to expose the second region (230b; 532) to the outside after providing of the power (P1) is bypassed.

12. The electronic device(101) according to claim 1, wherein the processor (120) is configured to:
identify whether the temperature of the second region (230b; 532) is less than a threshold temperature (T1) during a specified time duration (s2) according to a specified time interval (s1) based on identifying the second region (230b; 532) being rolled into the first housing (210);
in response to identifying that the temperature is lower than the threshold temperature (T1), provide the power (P1) to the first coil (510) during the specified time duration (s2) from a timing when the processor identifies the temperature is less than the threshold temperature(T1), and
in response to identifying that the temperature is equal to or higher than the threshold temperature (T1), bypass providing the power (P1) to the first coil (510) during the specified time duration (s2).

13. The electronic device(101) according to claim 1, wherein the processor (120) configured to:
based on the data representing the temperature of the second region (230b; 532) to be below the threshold temperature (T1), provide the power (P1) to the first coil (510), and
based on the data representing the temperature of the second region (230b; 532) to be equal to or higher than the threshold temperature (T1), provide another power (P2) lower than the power (P1) to the first coil (510).

14. The electronic device (101) according to claim 13, wherein the processor (120) configured to keep providing the another power (P2) to the first coil (510) based on the data representing the temperature of the second region (230b; 532) to be equal to or higher than the threshold temperature (T1) and below another threshold temperature (T2) higher than the threshold temperature (T1), and
based on the data representing the temperature of the second region (230b; 532) to be equal to or higher than the another threshold temperature (T2), bypass providing the another power (P2) to the first coil (510).

15. The electronic device (101) of claim 1,
further comprising a second coil (520) electrically connected to the first coil (510) and configured to receive the power (P1) from the processor (120) based on the data representing the temperature of the second region (230b; 532); and
wherein the processor (120) configured to bypass providing the power (P1) to the second coil (520) among the first coil (510) and the second coil(520), based on identifying that the power (P1) is provided during reference time.
